# EUROPEAN PATENT SPECIFICATION

(11) **EP 2 674 968 B1**
(45) Date of publication and mention of the grant of the patent: **27.02.2019**
(21) Application number: 13020036.3
(22) Date of filing: 12.06.2013
(51) Int. Cl.: H01L 21/268, H01L 21/331, B23K 26/06

(54) **Semiconductor device manufacturing method and laser annealing apparatus**
Halbleitervorrichtungs-Herstellungsverfahren und Laserglühvorrichtung
Procédé de fabrication de dispositif semi-conducteur et appareil de recuit au laser

(30) Priority: 13.06.2012 JP 2012133355; 08.08.2012 JP 2012176436
(43) Date of publication of application: 18.12.2013
(73) Proprietor: SUMITOMO HEAVY INDUSTRIES, LTD., Tokyo 141-6025 (JP)
(72) Inventor: Sakuragi, Susumu, Yokosuka-shi, Kanagawa, 237-8555 (JP); Wakabayashi, Naoki, Yokosuka-shi, Kanagawa, 237-8555 (JP)
(74) Representative: Emde, Eric

(56) References cited:
- EP-A1- 2 674 967
- EP-A1- 2 884 522
- WO-A1-2011/065094
- WO-A1-2011/096326
- JP-A- 2005 136 218
- US-A1- 2009 227 121
- Toshio Joshua Kudo ET AL: "PN Junction Formation for High-Performance Insulated Gate Bipolar Transistors (IGBT); Double-Pulsed Green Laser Annealing Technique", MRS Online Proceedings Library, 1 January 2006 (2006-01-01), XP055260403, DOI: 10.1557/PROC-0912-C03-11 Retrieved from the Internet: URL:http://journals.cambridge.org/action/d isplayFulltext?type=1&fid=7994430&jid=OPL& volumeId=912&issueId=-1&aid=7994428&bodyId =&membershipNumber=&societyETOCSession= [retrieved on 2016-03-22]

## Description

### BACKGROUND OF THE INVENTION

### Field of the Invention

The present invention relates to a semiconductor device manufacturing method and a laser annealing apparatus that activate dopants implanted into a semiconductor substrate by irradiation with a laser beam.

### Description of Related Art

A semiconductor device manufacturing method of forming an electrode layer and a field stop layer by introducing dopants into a semiconductor substrate by ion implantation and then irradiating the semiconductor substrate with a laser beam to activate the dopants is disclosed in JP 2010-171057 A. In the technique described in JP 2010-171057 A, a surface structure of a semiconductor device is manufactured and then the substrate decreases in thickness. Thereafter, ion implantation is performed on the rear surface thereof and the rear surface is irradiated with pulse laser beams using two laser oscillators. The time difference between the laser pulses emitted from the two laser oscillators is set to be equal to or less than 600 ns.

Specifically, for example, phosphorus ions are ion-implanted into a field stop layer forming region from the rear surface of an n⁻ type silicon substrate. At this time, the dose is set to be equal to or less than 1×10¹⁴ cm⁻² so that the peak concentration in the field stop layer is equal to or less than 5×10¹⁸ cm⁻³. Subsequently, for example, boron ions and phosphorus ions are implanted into a p⁺ type collector layer forming region and an n⁺ type cathode layer forming region with a dose set to 5×10¹⁶ cm⁻² so that the peak concentrations in a p⁺ type collector layer and an n⁺ type cathode layer are equal to or less than 1×10²¹ cm⁻³.

It is known that the n⁺ type cathode layer and the like into which ions are implanted with a high concentration is changed to be amorphous because the crystallinity of the silicon substrate is destroyed. In the semiconductor device manufacturing method described in JP 2010-171057 A, defect recovery due to solid-phase diffusion and activation of dopants implanted into a deep portion with a depth of 1 µm or more from a laser-irradiated surface (rear substrate surface) are performed by the irradiation with a laser beam. A sufficient temperature rise and a sufficient heating time may not be secured and the activation of dopants may not be satisfactory. When the pulse energy density of the laser beam to be irradiated is raised for satisfactory activation in the deep portion, the melting depth may become excessively large . When the deep portion is melted, the dopant concentration distribution in the depth direction may vary and the same characteristics as designed may not be obtained. Inconvenience such as an increase in roughness of the substrate surface may occur.

A technique of irradiating a semiconductor substrate with a pulse laser beam to perform laser annealing with such a pulse energy density not to melt the semiconductor substrate is proposed (for example, see JP 2009-32858 A). In this method, it is difficult to satisfactorily recover the crystallinity of the region into which dopants are ion-implanted with a high concentration and which is changed to be amorphous and to satisfactorily activate the implanted dopants.

EP 2 674 967 A1 forms part of the prior art under Art. 54 (3) EPC and discloses that a semiconductor substrate is prepared in which dopants are added to a relatively deep area of a surface layer portion at relatively low concentration and dopants are added to a relatively shallow area at relatively high concentration. The semiconductor substrate is irradiated with a laser beam so that high concentration dopants added to the relatively shallow area are activated by melting the semiconductor substrate to a position deeper than the area with the high concentration dopant added thereto and low concentration dopants added to the relatively deep area are activated without melting the semiconductor substrate to the area with the low concentration dopant added thereto. WO 2011/065094 A1 (JAPAN STEEL WORKS LTD [JP]; KUDO TOSHIO [JP]; KOBAYASHI NAOYUKI [JP];) 3 June 2011 (2011-06-03); & US 2012/234810 A1 (KUDO TOSHIO [JP] ET AL) 20 September 2012 (2012-09-20)discloses the activation of impurities implanted at the back side of an IGBT with two different laser pulses.

### SUMMARY OF THE INVENTION

An object of the present invention is to provide a semiconductor device manufacturing method and a laser annealing apparatus which can satisfactorily activate dopants implanted into a deep region and realize annealing with high quality.

According to an aspect of the present invention, there is provided a semiconductor device manufacturing method as set forth in claim 1.

According to this aspect of the present invention, it is possible to suppress surface roughness and to activate both a high-concentration region and a low-concentration region.

According to another aspect of the present invention, there is provided a laser annealing apparatus as set forth in claim 11.

According to this aspect of the present invention, it is possible to suppress surface roughness and to activate both a high-concentration region and a low-concentration region.

It is possible to suppress an increase in surface roughness .

### BRIEF DESCRIPTION OF THE DRAWINGS

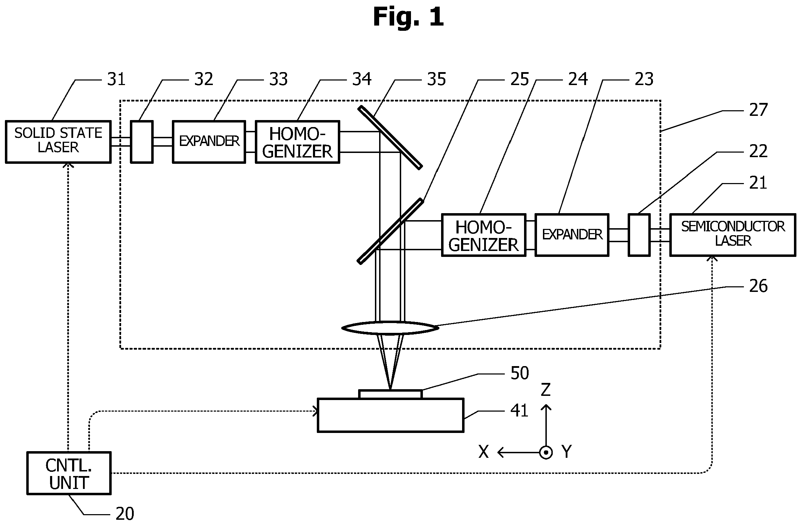

Fig. 1 is a diagram schematically illustrating a laser annealing apparatus according to an embodiment.

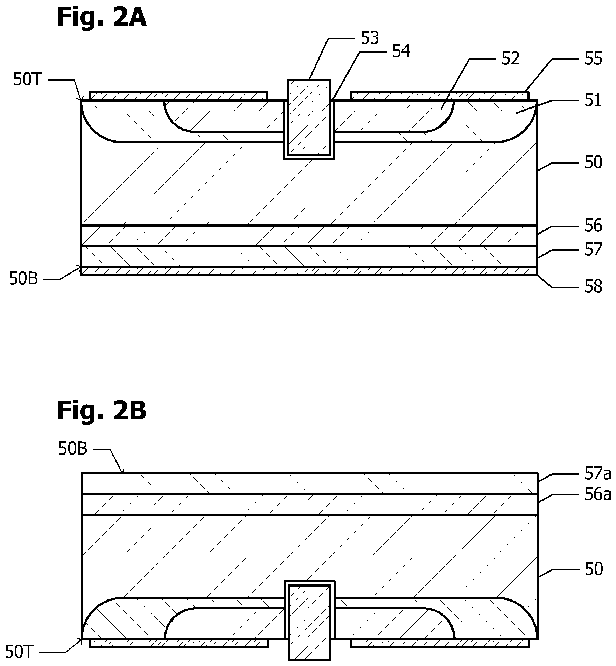

Fig. 2A is a cross-sectional view of an IGBT manufactured using a method according to an embodiment and Fig. 2B is a cross-sectional view of the IGBT in an annealing step using the laser annealing apparatus according to the embodiment.

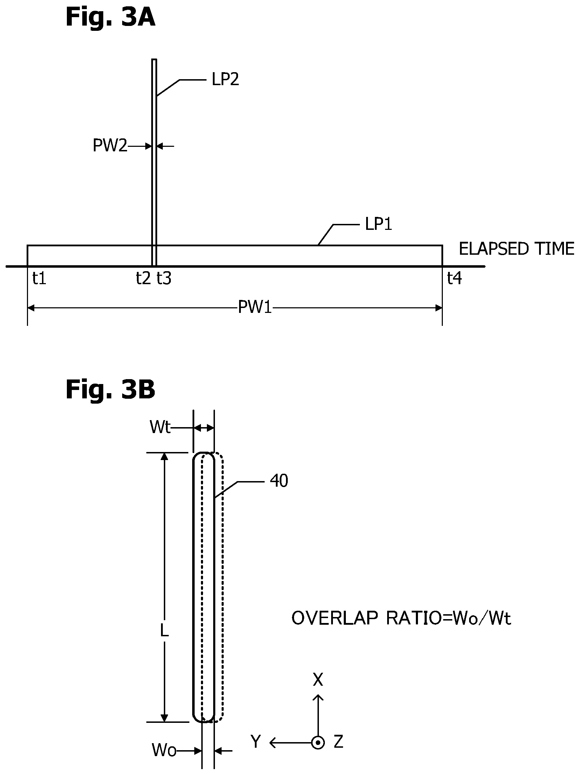

Fig. 3A is a graph illustrating a pulse waveform and an incidence timing of a laser pulse incident on a semiconductor substrate using the laser annealing apparatus according to the embodiment, Fig. 3B is a plan view of an incidence region of a laser pulse on the surface of the semiconductor substrate, and Fig. 3C is a plan view illustrating another configuration example of the incidence region of a laser pulse.

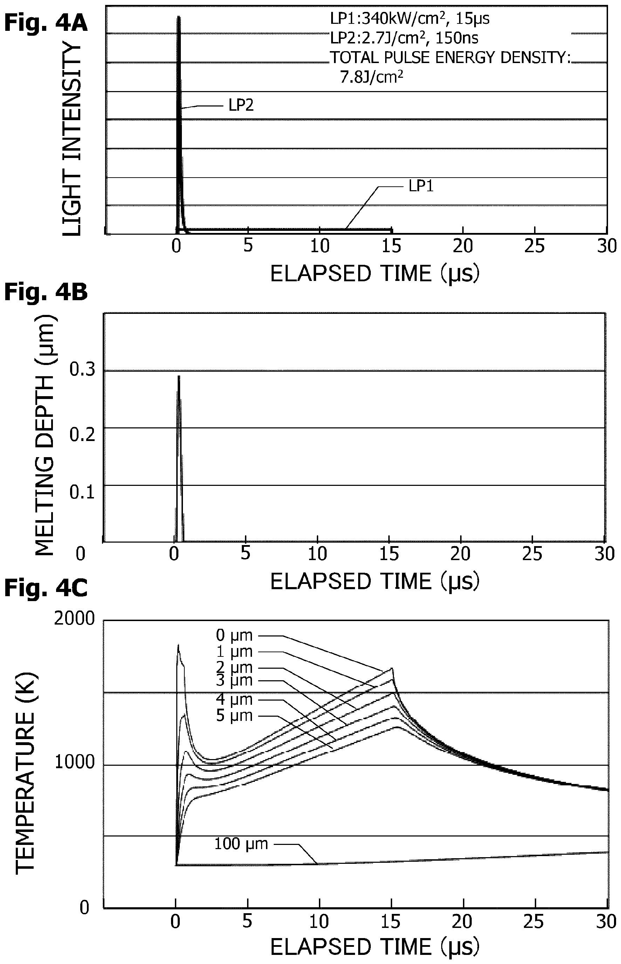

Fig. 4A is a graph illustrating a pulse waveform and an incidence timing of a laser pulse which is a first simulation target, Fig. 4B is a graph illustrating the temporal variation of a melting depth of the semiconductor substrate, and Fig. 4C is a graph illustrating the temporal variation of a temperature at depth positions in the semiconductor substrate.

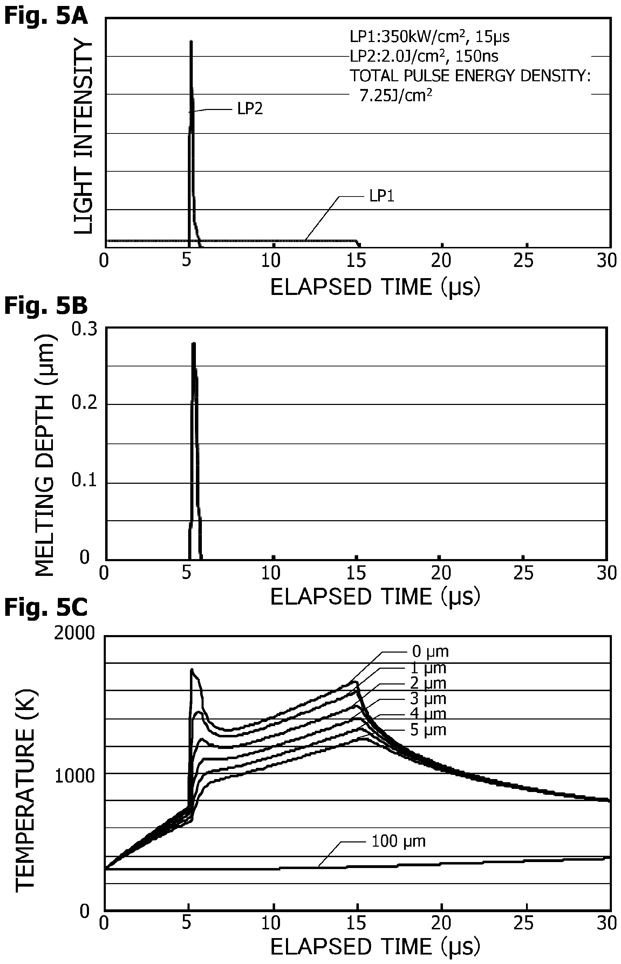

Fig. 5A is a graph illustrating a pulse waveform and an incidence timing of a laser pulse which is a second simulation target, Fig. 5B is a graph illustrating the temporal variation of a melting depth of the semiconductor substrate, and Fig. 5C is a graph illustrating the temporal variation of a temperature at depth positions in the semiconductor substrate.

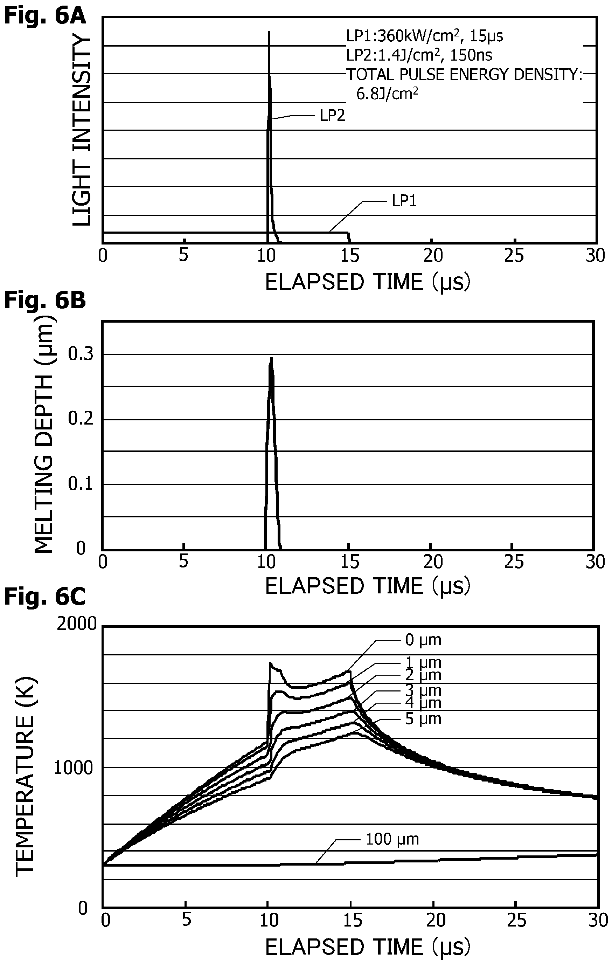

Fig. 6A is a graph illustrating a pulse waveform and an incidence timing of a laser pulse which is a third simulation target, Fig. 6B is a graph illustrating the temporal variation of a melting depth of the semiconductor substrate, and Fig. 6C is a graph illustrating the temporal variation of a temperature at depth positions in the semiconductor substrate.

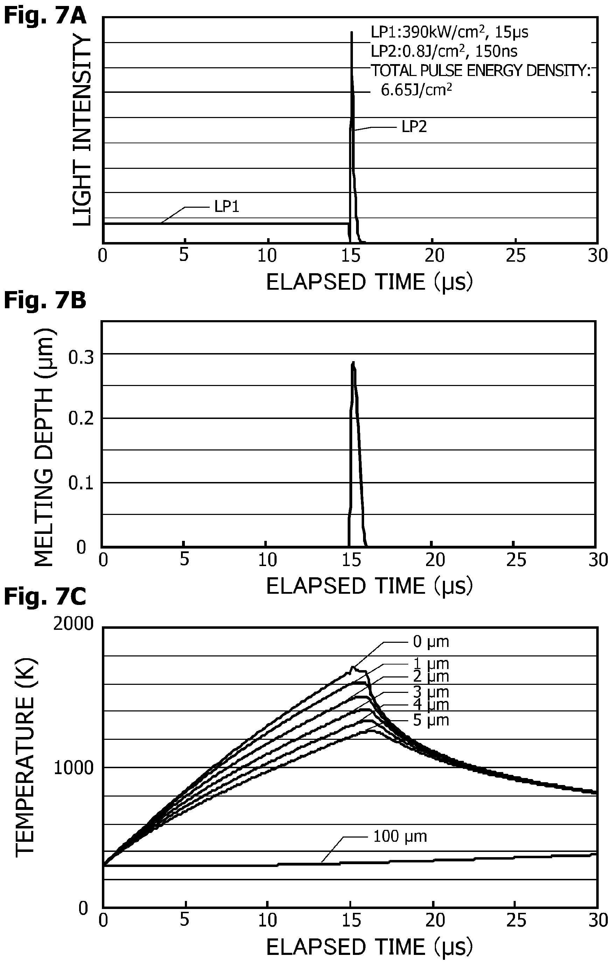

Fig. 7A is a graph illustrating a pulse waveform and an incidence timing of a laser pulse which is a fourth simulation target, Fig. 7B is a graph illustrating the temporal variation of a melting depth of the semiconductor substrate, and Fig. 7C is a graph illustrating the temporal variation of a temperature at depth positions in the semiconductor substrate.

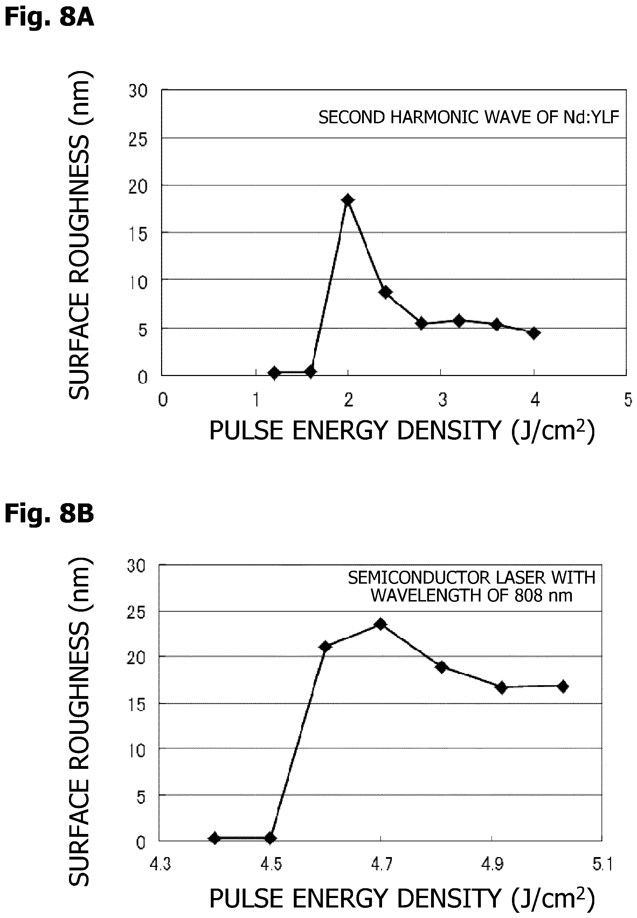

Fig. 8A is a graph illustrating the measurement result of surface roughness of the semiconductor substrate when laser annealing is performed using a second harmonic wave of Nd:YLF and Fig. 8B is a graph illustrating the measurement result of surface roughness of the semiconductor substrate when laser annealing is performed using a semiconductor laser with a wavelength of 808 nm.

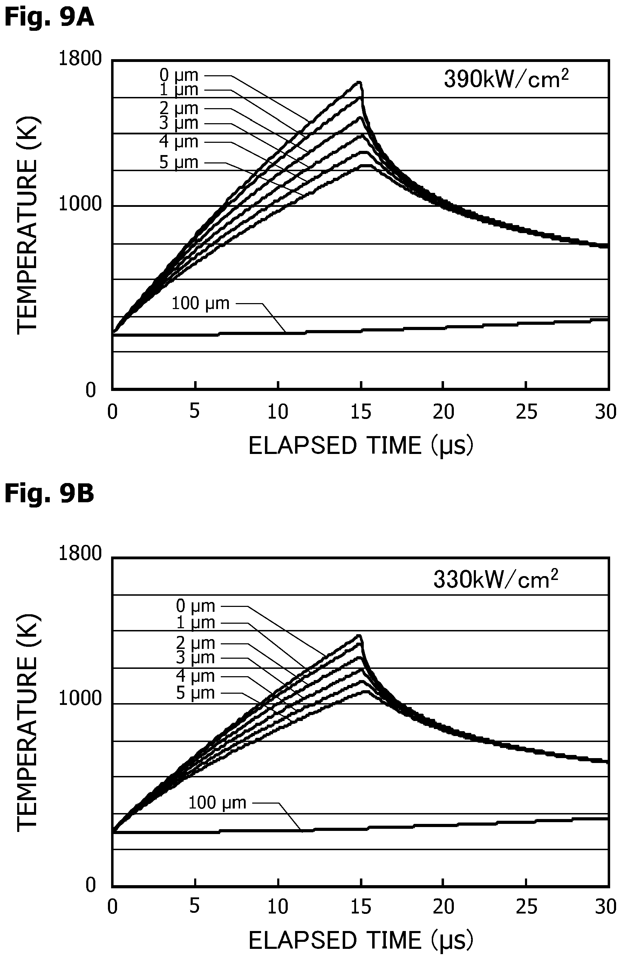

Figs. 9A and 9B are graphs illustrating the simulation result of the temperature variation of the semiconductor substrate when the semiconductor substrate is annealed under the conditions of power densities of 390 kW/cm² and 330kW/cm², respectively.

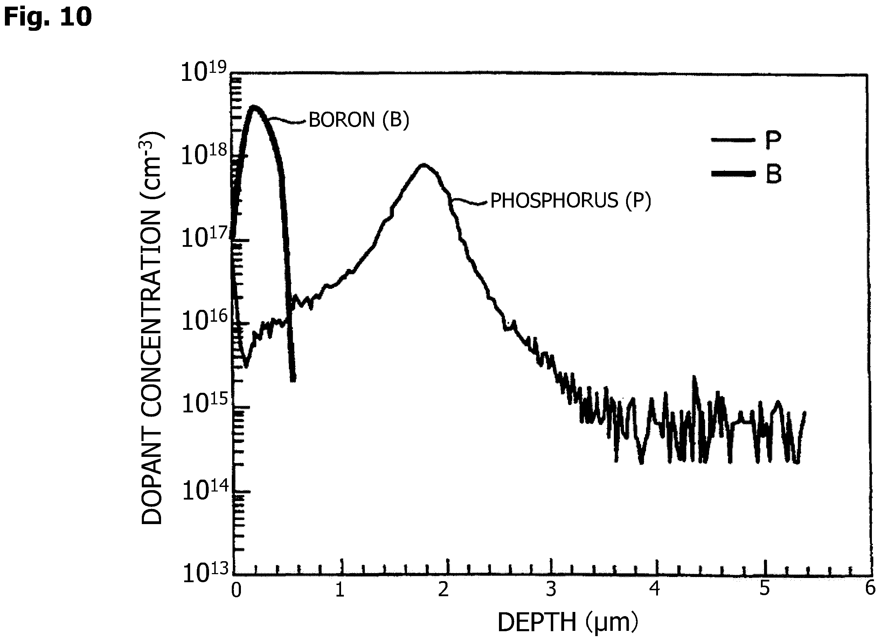

Fig. 10 is a graph illustrating an example of dopant concentration distributions in the depth direction of the semiconductor substrate.

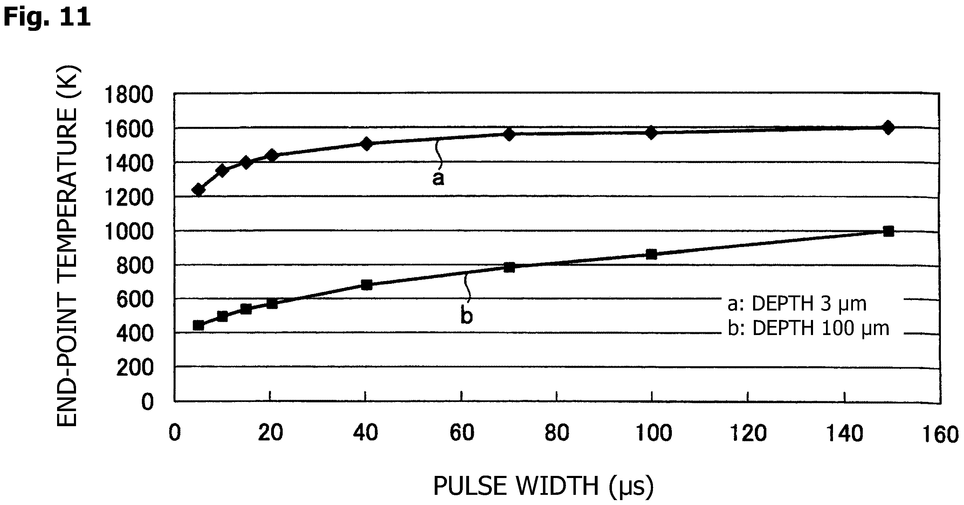

Fig. 11 is a graph illustrating the simulation result of the relationship between the end-point temperature of a silicon wafer and the pulse width when the silicon wafer is irradiated with a first laser pulse.

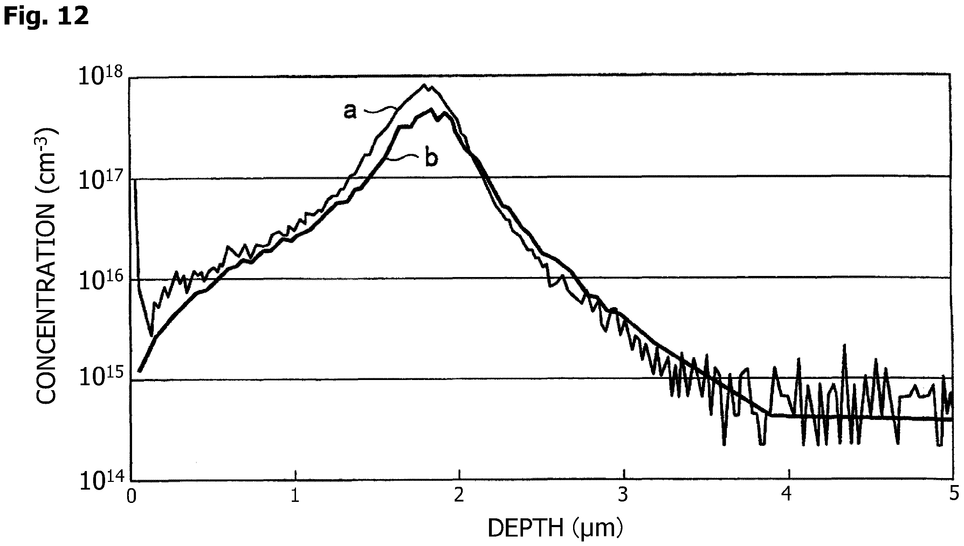

Fig. 12 is a graph illustrating a dopant concentration distribution and a carrier concentration distribution after annealing in the depth direction.

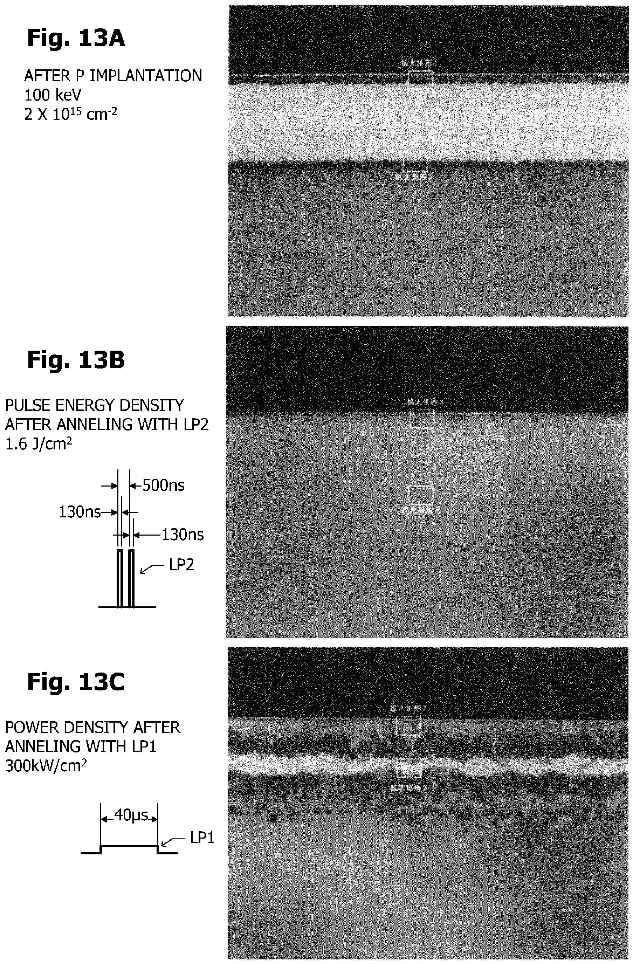

Fig. 13A is a TEM image illustrating a cross-section of the surface portion of a silicon wafer into which phosphorus ions are implanted, Fig. 13B is a TEM image illustrating a cross-section of the surface portion of the silicon wafer after it is irradiated with a second laser pulse, and Fig. 13C is a TEM image illustrating a cross-section of the surface portion of the silicon wafer after it is irradiated with a first laser pulse.

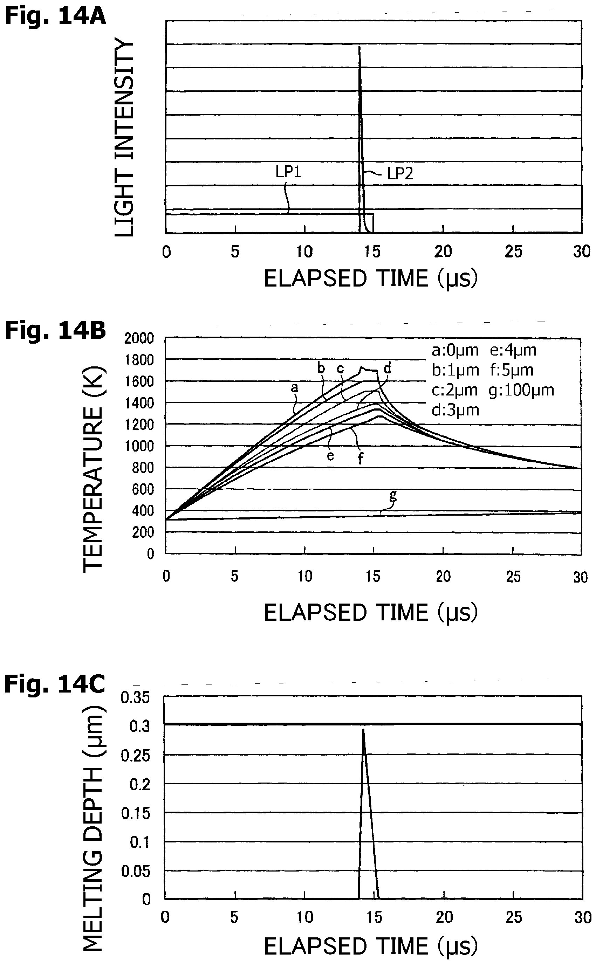

Fig. 14A is a graph illustrating an example of a temporal waveform of a laser pulse when laser annealing is performed using the method according to the embodiment, Fig. 14B is a graph illustrating the simulation result of the temperature variation of a silicon wafer when the silicon wafer is irradiated with the first and second laser pulses shown in Fig. 14A, and Fig. 14C is a graph illustrating the simulation result of the temporal variation of the melting depth of the silicon wafer.

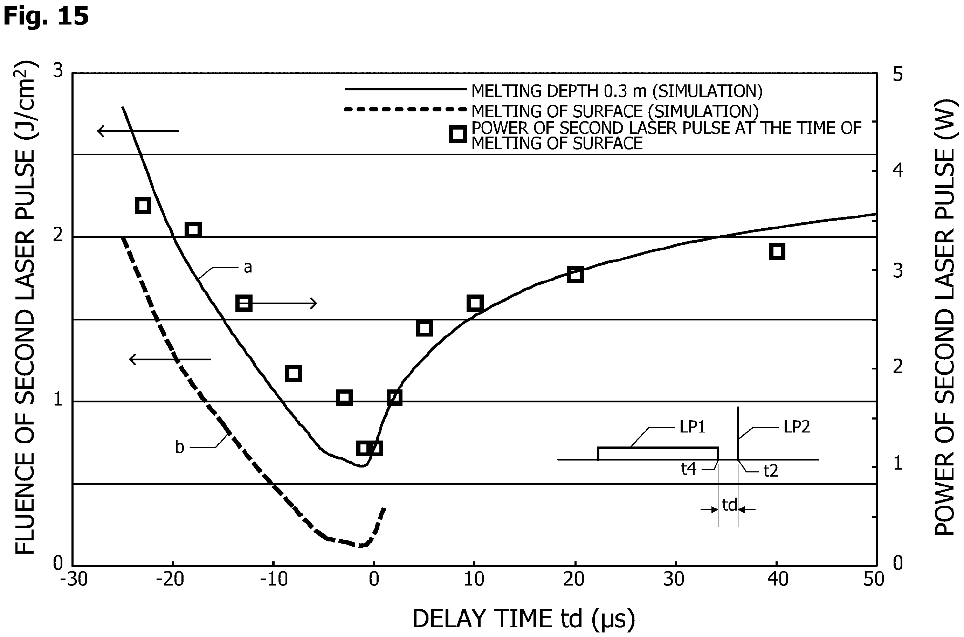

Fig. 15 is a graph illustrating the relationship between an elapsed time (delay time) from the falling point of the first laser pulse to the rising point of the second laser pulse and the fluence of the second laser pulse necessary for melting the silicon wafer.

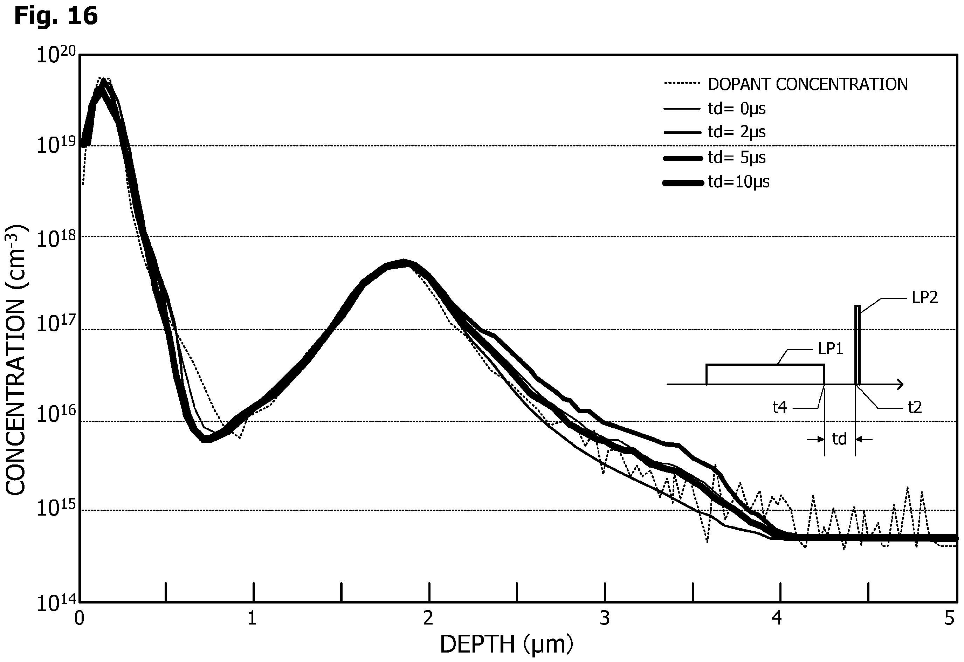

Fig. 16 is a graph illustrating the measurement result of a dopant concentration distribution before activation annealing and carrier concentration distributions after activation annealing.

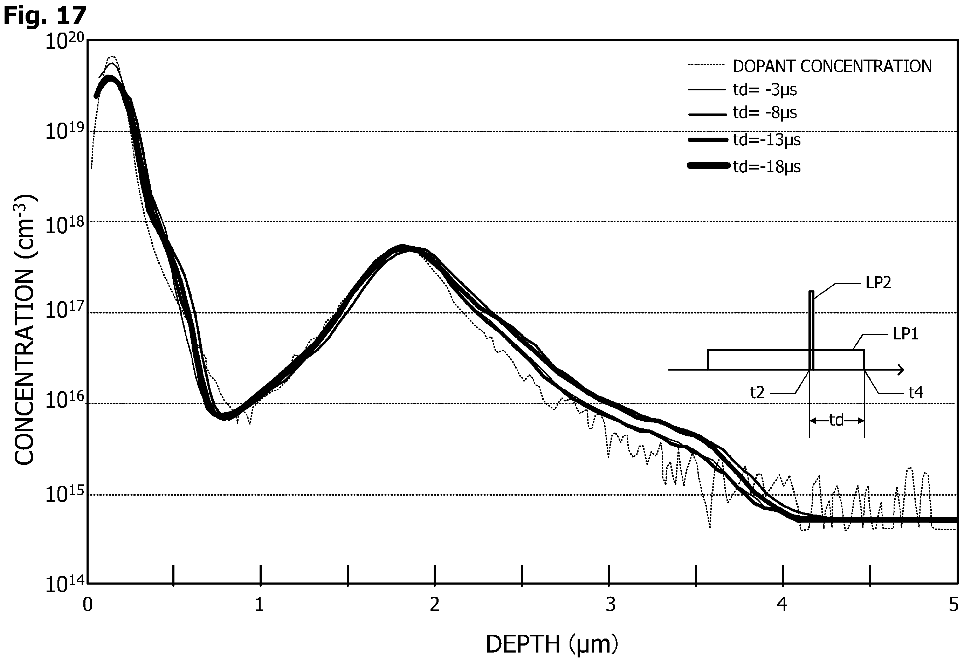

Fig. 17 is a graph illustrating the measurement result of a dopant concentration distribution before activation annealing and carrier concentration distributions after activation annealing.

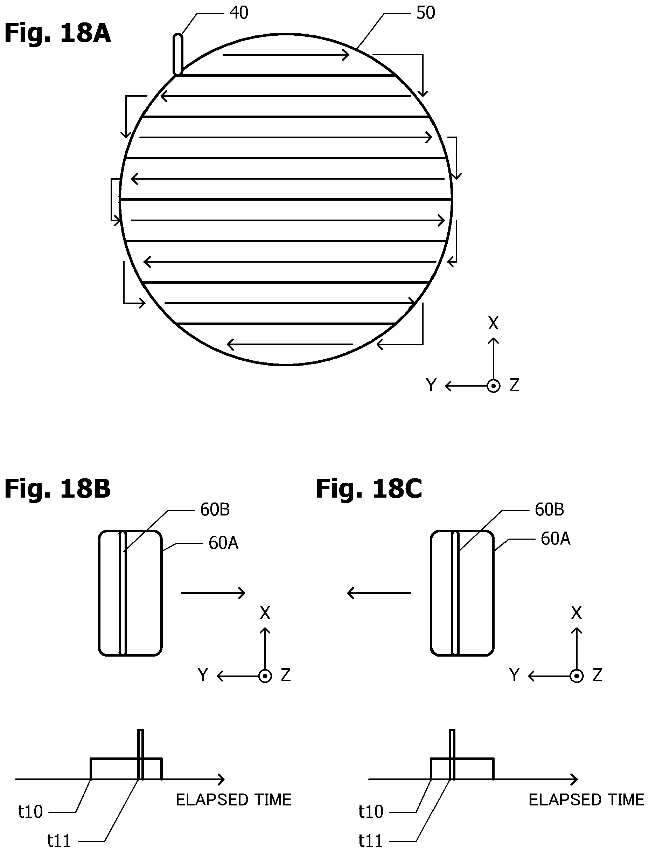

Fig. 18A is a plan view illustrating a scanning path of a pulse laser beam when activation-annealing the entire surface of a semiconductor wafer and Figs. 18B and 18C are a plan view of a laser incidence region when annealing is performed using a continuous-wave laser beam and a pulse laser beam and a graph illustrating the temporal variation of laser energy incident on one point of the semiconductor wafer, respectively.

### DETAILED DESCRIPTION OF THE INVENTION

Before describing embodiments of the present invention, the result of an evaluation test carried out by the inventor will be described below. Aboron-implanted layer with a thickness of 0.2 µm to 0.25µm was formed by implanting boron ions into the surface portion of a substrate formed of a single crystal silicon. The boron-implanted layer was changed to be amorphous. The surface portion was re-crystallized and boron ions were activated, by irradiating the substrate having the surface portion changed to be amorphous with a pulse laser beam.

Two samples of Sample 1 and Sample 2 in which the pulse laser beams have different irradiation conditions were formed. The incidence condition of the pulse laser beam for Sample 1 is as follows.
- Type of laser: second harmonic wave of Nd:YLF laser
- Number of incident pulses: double pulses
- Delay time of second-shot pulse from first-shot pulse: 300 ns to 700 ns
- Pulse width: 100 ns to 200 ns

The incidence condition of the pulse laser beam for Sample 2 is as follows.
- Type of laser: QCW semiconductor laser with wavelength of 808 nm
- Number of incident pulses: single pulse
- Pulse width: 10 ns to 20 µs

The laser irradiation condition for Sample 1 and the laser irradiation condition for Sample 2 have the largest difference in pulse width. Specifically, the pulse width of the pulse laser beam incident on Sample 2 is about 100 times the pulse width of the pulse laser beam incident on Sample 1. When both pulse laser beams have the same degree of pulse energy, it means that the peak power density of the pulse laser beam incident on Sample 1 is about 100 times the peak power density of the pulse laser beam incident on Sample 2.

In general, a pulse laser beam having a short pulse width and a large peak power density can be suitably used to heat only the very shallow surface portion of a substrate . On the contrary, a pulse laser beam having a long pulse width and a small peak power density can be suitably used to heat a deep region, because heat introduced into the substrate can be easily transmitted to the deep region.

Figs. 8A and 8B illustrate the surface roughness after annealing Sample 1 and Sample 2 with a laser. The horizontal axis represents the pulse energy density of the pulse laser beam incident on the substrate in the unit of "J/cm²" and the vertical axis represents the root-mean-square roughness (Rq) of the surface in the unit of "nm".

In a region in which the pulse energy density in Fig. 8A is equal to or less than 1.5 J/cm² and a region in which the pulse energy density in Fig. 8B is equal to or less than 4.5 J/cm², the melting and re-crystallizing of the surface of the substrate do not occur. When the pulse energy density in Fig. 8A is 2 J/cm² and the pulse energy density in Fig. 8B is 4.6 J/cm², the surface roughness rapidly increases. This is because an amorphous layer of the surface of the substrate is once melted and then re-crystallized. The lower limit value of the pulse energy density at which the amorphous layer is melted is referred to as a "melting threshold value".

As shown in Fig. 8A, when the pulse energy density is set to be larger than the melting threshold value, the surface roughness decreases. When the pulse energy density is equal to the melting threshold value, it is thought that a region which is sufficiently melted and a region which is insufficiently melted are mixed in a plane. Accordingly, the surface roughness after re-crystallization is large. When the pulse energy density is larger than the melting threshold value and the surface of the substrate is substantially uniformly melted, the surface roughness after re-crystallization is small.

In Sample 2 shown in Fig. 8B, even when the pulse energy density is larger than the melting threshold value, the decrease in surface roughness is smaller than that in Sample 1. It is thought that the reason why the decrease in surface roughness is small is because the substrate is not uniformly melted in the in-plane direction of the substrate even when the pulse energy density increases . It is thought that the reason why the melting is not uniform is because absorption of light with a wavelength of 808 nm is greatly different between liquid and solid, the light absorbance of a portion which is early melted and changed to liquid increases, and thus the temperature thereof locally rises. From this knowledge, it is preferable that the surface be rapidly melted when annealing and melting the surface.

In order to activate dopants implanted into the rear surface of the substrate of an insulating gate bipolar transistor (IGBT), it is necessary to heat the region with a depth of 1 µm to 5 µm at a temperature of 1200 K or higher. It is difficult to satisfactorily heat the deep region by the use of a solid state laser used to anneal Sample 1. A QCW semiconductor laser with a long pulse width used to anneal Sample 2 can be effectively used to heat the deep region. When the semiconductor laser is used, the surface roughness of the substrate is likely to increase as shown in Fig. 8B.

Figs. 9A and 9B show the simulation results of the temporal variation of the substrate temperature when the substrate is annealed using the semiconductor laser under the conditions of power densities of 390 kW/cm² and 330 kW/cm² on the substrate surfaces. The horizontal axis represents the elapsed time in the unit of "µs" and the vertical axis represents the temperature in the unit of "K". The numerical values described in the solid lines in the drawings represent the depth from the substrate surface. The pulse width of the pulse laser beam is set to 15 µs.

In the example shown in Fig. 9A, the power density of the laser pulse is determined so that the temperature of the position at a depth of 5 µm is equal to or more than 1200 K at the time when 15 µs has elapsed from the incidence start point of the laser pulse. At this time, the temperature of a region with a depth shallower than 3 µm is higher than the melting point (1300 K to 1430 K) of amorphous silicon. Accordingly, the surface of the substrate is melted. Once the surface is melted, the surface roughness after re-crystallization increases as shown in Fig. 8B.

In the example shown in Fig. 9B, the power density of the laser pulse is determined so that the surface temperature of the substrate is not higher than the melting point of amorphous silicon at the time when 15 µs has elapsed from the incidence start point of the laser pulse. Under this condition, the temperature of a region with a depth deeper than 3 µm does not reach 1200 K. Accordingly, the dopants in the region with a depth deeper than 3 µm cannot be satisfactorily activated.

In the embodiments described below, it is possible to suppress an increase in surface roughness of a substrate and to satisfactorily activate dopants in a deep region with a depth of about 5 µm. When circuits are formed on the opposite side of the side irradiated with a laser beam, it is necessary to sufficiently consider that the temperature rise of the circuit side should be maintained to be lower than a predetermined temperature. It is necessary to sufficiently consider that the deep region (for example, with a depth of 3 µm) reaches a predetermined activation temperature. It is necessary to sufficiently consider that a shallow region (for example, with a depth of 1 µm or less) needs to be melted. The laser conditions for satisfying the above-mentioned conditions as much as possible will be verified through the use of simulations and experiments.

Fig. 1 is a diagram schematically illustrating a laser annealing apparatus according to an embodiment. A semiconductor laser oscillator (first laser oscillator) 21 emits, for example, a QCW laser beam with a wavelength of 808 nm. A semiconductor laser oscillator emitting a pulse laser beam with a wavelength equal to or shorter than 950 nm may be used. A solid state laser oscillator (second laser oscillator) 31 emits a pulse laser beam of a green wavelength band. For example, a Nd:YAG laser, a Nd:YLF laser, or a Nd:YVO₄ laser emitting a second harmonic wave are used as the solid state laser oscillator 31.

The pulse laser beam emitted from the semiconductor laser oscillator 21 and the pulse laser beam emitted from the solid state laser oscillator 31 are incident on a semiconductor substrate 50 to be annealed via a propagating optical system 27. The pulse laser beam emitted from the semiconductor laser oscillator 21 and the pulse laser beam emitted from the solid state laser oscillator 31 are incident on the same region of the surface of the semiconductor substrate 50.

The configuration and operation of the propagating optical system 27 will be described below. The pulse laser beam emitted from the semiconductor laser oscillator 21 is incident on the semiconductor substrate 50 via an attenuator 22, a beam expander 23, a homogenizer 24, a dichroic mirror 25, and a condensing lens 26.

The pulse laser beam emitted from the solid state laser oscillator 31 is incident on the semiconductor substrate 50 via an attenuator 32, a beam expander 33, a homogenizer 34, a bending mirror 35, the dichroic mirror 25, and the condensing lens 26.

The beam expanders 23 and 33 collimate incident pulse laser beams and enlarge the beam diameters thereof. The homogenizers 24 and 34 and the condensing lens 26 shape a beam cross-sections on the surface of the semiconductor substrate 50 in an elongated shape and uniformize the light intensity distributions in the beam cross-sections. The pulse laser beam emitted from the semiconductor laser oscillator 21 and the pulse laser beam emitted from the solid state laser oscillator 31 are incident substantially on the same elongated region on the surface of the semiconductor substrate 50.

The semiconductor substrate 50 is supported by a stage 41. An XYZ orthogonal coordinate system having a plane parallel to the surface of the semiconductor substrate 50 as the XY plane and having the normal direction of the surface of the semiconductor substrate 50 as the Z direction is defined. The control unit 20 controls the semiconductor laser oscillator 21, the solid state laser oscillator 31, and the stage 41. The stage 41 causes the semiconductor substrate 50 to move in the X direction and the Y direction under the control of the control unit 20.

Fig. 2A is a cross-sectional view of an insulating gate bipolar transistor (IGBT) as an example of a semiconductor device manufactured using the method according to the embodiment. The IGBT is manufactured by forming an emitter and a gate on one surface (hereinafter, referred to as a "first surface") 50T of the semiconductor substrate 50 made of n type silicon and forming a collector on the other surface (hereinafter, referred to as a "second surface") 50B. The structure of the surface on which the emitter and the gate are formed is manufactured using the same manufacturing processes as manufacturing a typical MOSFET. For example, as shown in Fig. 2A, a p type base region 51, an n type emitter region 52, a gate electrode 53, a gate insulating film 54, and an emitter electrode 55 are disposed on the surface portion of the first surface 50T of the semiconductor substrate 50. The ON and OFF operation of current can be performed using the gate-emitter voltage.

A p type collector layer 57 and a low-concentration n type buffer layer 56 are formed in the surface portion of the second surface 50B of the semiconductor substrate 50. The buffer layer 56 is disposed in a region deeper than the collector layer 57. The collector layer 57 and the buffer layer 56 are formed by ion-implanting, for example, boron and phosphorus as dopants, respectively, and performing activation annealing thereof. The laser annealing apparatus shown in Fig. 1 is used for the activation annealing. The collector electrode 58 is formed on the surface of the collector layer 57 after the activation annealing.

The depth from the second surface to the boundary between the collector layer 57 and the buffer layer 56 is, for example, about 0.3 µm. The depth from the second surface to the deepest position of the buffer layer 56 is, for example, in a range of 1 µm to 5 µm.

Fig. 2B shows a cross-sectional view of the semiconductor substrate 50 in the laser annealing step. Boron ions are implanted into the surface portion 57a of the second surface 50B of the semiconductor substrate 50. Phosphorus ions are implanted into a region 56a deeper than the surface portion 57a. Boron ions in the surface portion 57a and phosphorus ions in the deep region 56a are not activated. The boron concentration of the surface portion 57a is higher than the phosphorus concentration of the deep region 56a. In this specification, the surface portion 57a is referred to as a "high-concentration layer" and the deep region 56a is referred to as a "low-concentration layer". Since the dose of boron is large, the high-concentration layer 57a is in an amorphous state. A region deeper than the boundary between the high-concentration layer 57a and the low-concentration layer 56a is in a single crystalline state. The element structure shown in Fig. 2A is formed on the first surface 50T of the semiconductor substrate 50.

Fig. 3A is a diagram schematically illustrating a laser pulse waveform incident on the semiconductor substrate 50 (Fig. 2B). In Fig. 3A, the pulse waveform is shown as a rectangle, but the actual pulse waveform includes a rising portion, an attenuating portion, and a falling portion of a pulse. The emission timing of the pulse waveform shown in Fig. 3A is determined by the control unit 20 (Fig. 1) controlling the semiconductor laser oscillator 21 and the solid state laser oscillator 31.

At time t1, incidence of a first laser pulse LP1 emitted from the semiconductor laser oscillator 21 on the semiconductor substrate 50 starts. At time t2 subsequent to time t1, a second laser pulse LP2 emitted from the solid state laser oscillator 31 is incident on the semiconductor substrate 50. The regions on which the first laser pulse LP1 and the second laser pulse LP2 are incident substantially overlap with each other. The peak power of the second laser pulse LP2 is higher than the peak power of the first laser pulse LP1, and the pulse width PW2 of the second laser pulse LP2 is shorter than the pulse width PW1 of the first laser pulse LP1. At time t3, the incidence of the second laser pulse LP2 ends. Thereafter, at time t4, the incidence of the first laser pulse LP1 ends. After time t4, the second laser pulse LP2 may be incident.

The pulse width PW1 of the first laser pulse LP 1 is, for example, equal to or longer than 10 µs. The pulse width PW2 of the second laser pulse LP2 is, for example, equal to or shorter than 1 µs. For example, the pulse width PW1 is in a range of 10 µs to 30 µs and the pulse width PW2 is in a range of 100 ns to 200 ns. The pulse width PW2 of the second laser pulse LP2 is preferably set to be equal to or shorter than 1/10 of the pulse width PW1 of the first laser pulse LP1.

Fig. 3B shows a plan view of the incidence region of the laser pulses on the second surface 50B of the semiconductor substrate 50 (Fig. 2B). The first laser pulse LP1 (Fig. 3A) and the second laser pulse LP2 (Fig. 3A) are incident on the same region 40 which is elongated in the X direction on the second surface 50B (Fig. 2B) of the semiconductor substrate 50. For example, the length L and the width Wt of the beam incident region 40 are preferably in a range of 2 mm to 4 mm and a range of 200 µm to 400 µm, respectively.

During annealing, the first laser pulse LP1 and the second laser pulse LP2 (Fig. 3A) are incident on the semiconductor substrate 50 with a constant repetition frequency while causing the semiconductor substrate 50 (Fig. 2B) to move in the Xdirection. In one cycle of the repetition frequency of the first laser pulse LP1 and the second laser pulse LP2, the distance by which the semiconductor substrate 50 moves is represented as Wo. The beam incident regions 40 of two first laser pulses LP1 neighboring each other in the time axis partially overlap with each other. The overlap ratio Wo/Wt of both is, for example, 50%.

When the incidence of the first laser pulse LP1 starts at time t1 shown in Fig. 3A, the temperature of the surface portion of the second surface 50B (Fig. 2B) of the semiconductor substrate 50 starts to rise. At the time point of time t2, the temperature of the second surface 50B of the semiconductor substrate 50 does not reach the melting point (1300 K to 1430 K) of amorphous silicon. When the second laser pulse LP2 is incident at time t2, the temperature of the surface portion of the second surface 50B of the semiconductor substrate 50 reaches the melting point of amorphous silicon and the surface portion is thus melted. The melted portion reaches the bottom of the high-concentration layer 57a (Fig. 2B).

When the incidence of the second layer pulse LP2 ends, the temperature of the surface portion of the semiconductor substrate 50 is lowered and the surface portion is solidified. At this time, since a crystal epitaxially grows from the single crystalline low-concentration layer 56a (Fig. 2B), the high-concentration layer 57a becomes a single crystal. At the same time, the dopants implanted into the high-concentration layer 57a are activated. Similarly to the example shown in Fig. 8A, since the melting and the solidification are generated by the second laser pulse LP2 (Fig. 3A) having high peak power and a small pulse width, it is possible to suppress an increase in surface roughness of the semiconductor substrate 50 after the solidification.

Since the first laser pulse LP1 (Fig. 3A) is continuously incident even after time t3, the low-concentration layer 56a which is located in a deep portion from the second surface 50B of the semiconductor substrate 50 is heated and the temperature thereof rises. Accordingly, the dopants implanted into the low-concentration layer 56a (Fig. 2B) are activated. At time t4, the temperature of the second surface 50B of the semiconductor substrate 50 does not reach the melting point of single crystalline silicon at the time point at which the incidence of the first laser pulse LP1 ends. Accordingly, the surface portion of the second surface 50B of the re-crystallized semiconductor substrate 50 is not re-melted. The surface portion of the semiconductor substrate 50 is not melted by the incidence of the first laser pulse LP1 (Fig. 3A) having low peak power and a long pulse width. As a result, the increase in surface roughness of the semiconductor substrate 50 shown in Fig. 8B does not occur.

In order to achieve the above-mentioned advantages, it is preferable that the pulse width PW1 of the first laser pulse LP1 be set to be equal to or longer than 5 µs. It is also preferable that the pulse width PW2 of the second laser pulse LP2 be set to be equal to or shorter than 1 µs. When the pulse waveform of the first laser pulse LP1 is different from that shown in Fig. 3A and the output of laser beam intensity is not constant, the pulse width PW1 is preferably set to be equal to or longer than 10 µs in terms of the full width at half maximum (FWHM). Here, when the laser beam intensity increases only in a very short time like a spike, the pulse width may not be expressed accurately using the half value of the peak intensity. Accordingly, the FWHM of the average intensity may be adopted as the pulse width in this case.

In Fig. 3B, the incidence region 40 of the first laser pulse LP1 and the incidence region 40 of the second laser pulse LP2 on the surface of the semiconductor substrate 50 are substantially matched, but both do not have to be matched. As shown in Fig. 3C, the incidence region 40A of the first laser pulse LP1 may be set to be slightly larger than the incidence region 40B of the second laser pulse LP2. In this case, the incidence region 40B of the second laser pulse LP2 is included in the incidence region 40A of the first laser pulse LP1.

When the incidence region 40A of the first laser pulse LP1 and the incidence region 40B of the second laser pulse LP2 are equal in area and are matched, a margin for misalignment of optical axes therebetween is not substantially present. As shown in Fig. 3C, in the case where the incidence region 40A of the first laser pulse LP1 is set to be larger than the incidence region 40B of the second laser pulse LP2, even when the optical axes thereof are mismatched but the mismatched amount is small, the incidence region 40B of the second laser pulse LP2 remains included in the incidence region 40A of the first laser pulse LP1. Accordingly, the margin for aligning the optical axes can be made large.

In the region in which the incidence region 40A of the first laser pulse LP1 and the incidence region 40B of the second laser pulse LP2 overlap, the activation of dopants in the high-concentration layer 57a and the low-concentration layer 56a (Fig. 2B) is performed. When the incidence region 40A of the first laser pulse LP1 is set to be excessively larger than the incidence region 40B of the second laser pulse LP2, an overlap ratio of the first laser pulse LP1 is excessively high and a waste of energy increases. The overlap ratio of the first laser pulse LP1 is preferably equal to or more than 50%. The second laser pulse should be applied so as to not form a gap between two incidence regions of two shots neighboring in the time axis. In order to satisfy these requirements and to reduce the waste of irradiation energy, it is preferable that the area of the incidence region 40B of the second laser pulse LP2 be set to be in a range of 50% to 100% of the incidence region 40A of the first laser pulse LP1.

In order to raise the temperature of the deep portion of the semiconductor substrate 50, it is preferable that the pulse energy density of the first laser pulse LP1 be set to be larger under the condition that the surface portion of the semiconductor substrate 50 is not melted. In the method according to this embodiment, the surface portion of the semiconductor substrate 50 is crystallized at time t3 shown in Fig. 3A. In the case where the surface portion is crystalized, it is seen that it is more difficult to melt the surface portion than in a case where the surface portion is in an amorphous state. Therefore, even under the condition that the amorphous layer is melted by irradiation of the semiconductor substrate with only the first laser pulse LP1, the surface portion is not melted when the surface portion is crystallized. Accordingly, it is possible to heat the deep region of the semiconductor substrate 50 with an increased pulse energy density of the first laser pulse LP1.

The simulation results having different laser irradiation conditions will be described below with reference to Figs. 4A to 7C. Figs. 4A, 5A, 6A, and 7A show the incidence timings and the pulse waveforms of the first laser pulse LP1 and the second laser pulse LP2. Figs. 4B, 5B, 6B, and 7B show temporal variation of the melting depth of a substrate when an annealing operation is performed under the conditions shown in Figs. 4A, 5A, 6A, and 7A. A single crystalline silicon substrate is used as the substrate to be tested. Figs. 4C, 5C, 6C, and 7C show the temperature variation of the substrate when the annealing operation is performed under the conditions shown in Figs. 4A, 5A, 6A, and 7A. Temperatures at positions with depths of 0 µm, 1 µm, 2 µm, 3 µm, 4 µm, 5 µm, and 100 µm are given as examples of the substrate temperatures.

Under any laser irradiation condition, the pulse width PW1 of the first laser pulse LP1 and the pulse width PW2 (Fig. 3A) of the second laser pulse LP2 are set to 15 µs and 150 ns, respectively. The pulse energy density of the second laser pulse is set to such a magnitude in which the depth of the melted portion of the silicon substrate is about 0.3 µm. The depth value of 0.3 µm is determined by assuming that the bottom surface of the high-concentration layer 57a shown in Fig. 2B is melted. The power density of the first laser pulse LP1 is set to such a magnitude in which the temperature at a position with a depth of 5 µm in the silicon substrate is equal to or higher than 1200 K at the time point of ending the incidence of the first laser pulse LP1.

In the example shown in Fig. 4A, the incidence start time of the second laser pulse LP2 is matched with the incidence start time of the first laser pulse LP1. In the example shown in Fig. 5A, the second laser pulse LP2 is incident at the time point when 5 µs has elapsed from the time point at which the incidence of the first laser pulse LP1 is started. In the example shown in Fig. 6A, the second laser pulse LP2 is incident at the time point when 10 µs has elapsed from the time point at which the incidence of the first laser pulse LP1 is started. In the example shown in Fig. 7A, the second laser pulse LP2 is incident at the time point when 15 µs has elapsed from the time point at which the incidence of the first laser pulse LP1 is started, that is, at the time point at which the incidence of the first laser pulse LP1 is stopped.

As shown in Figs. 4B, 5B, 6B, and 7B, under any annealing condition, the depth of the melted portion of the silicon substrate is about 0.3 µm. The pulse energy densities of the second laser pulses LP2 under the annealing conditions shown in Figs. 4A, 5A, 6A, and 7A are 2.7 J/cm², 2.0 J/cm², 1. 4 J/cm², and 0.8 J/cm², respectively. When the incident timing of the second laser pulse LP2 is delayed, the rise of the substrate temperature due to the incidence of the first laser pulse LP1 is achieved. Accordingly, the pulse energy density of the second laser pulse LP2 necessary for melting the surface portion with a depth of 0.3 µm is lowered.

In the example shown in Figs. 4A to 4C, the surface portion of the substrate is melted and crystallized in single crystals by the incidence of the second laser pulse LP2. The surface temperature of the substrate is higher than the melting point of amorphous silicon at the time point at which the incidence of the first laser pulse LP1 is stopped (Fig. 4C), but the re-melting of the surface portion does not occur because the surface portion is crystallized in single crystals at that time point. Since the melting due to the incidence of the first laser pulse LP1 does not occur, an increase in surface roughness of the substrate is suppressed. Here, in order to melt the surface portion to the position with a depth of 0.3 µm by the use of the second laser pulse LP2, it is necessary to raise the pulse energy density of the second laser pulse LP2 up to about 2.7 J/cm². Since it is difficult to secure this high pulse energy density by the use of a typical solid state laser oscillator, plural solid state laser oscillators should be prepared.

In the examples shown in Figs. 5A to 5C, the surface portion of the substrate is crystallized in single crystals by the incidence of the second laser pulse LP2. The surface temperature of the substrate is higher than the melting point of amorphous silicon at the time point at which the incidence of the first laser pulse LP1 is stopped (Fig. 5C), but the re-melting of the surface portion does not occur because the surface portion is crystallized in single crystals. At the time point at which the second laser pulse LP2 is incident, the substrate temperature is raised by the first laser pulse LP1. Accordingly, the pulse energy density of the second laser pulse LP2 necessary for melting the surface portion up to the position with a depth of 0.3 µm is 2.0 J/cm², which is lower than that in the example under the annealing condition shown in Figs. 4A to 4C.

In the example shown in Figs. 6A to 6C, the surface portion of the substrate is melted and crystallized in single crystals by the incidence of the second laser pulse LP2. At the time point at which the incidence of the first laser pulse LP1 is stopped, the surface temperature of the substrate is higher than the melting point of amorphous silicon (Fig. 6C), but the re-melting of the surface portion does not occur. The pulse energy density of the second laser pulse LP2 necessary for melting the surface portion up to the position with a depth of 0.3 µm is 1.4 J/cm², which is much lower than that in the example under the annealing condition shown in Figs. 5A to 5C.

In the example shown in Figs. 7A to 7C, the surface temperature of the substrate is higher than the melting point of amorphous silicon at the time point with an elapsed time of 11 µs to 12 µs as shown in Fig. 7C. Since the incidence of the second laser pulse LP2 is not performed up to that time point, the surface portion is melted in a case where the surface portion of the substrate is initially amorphous. Accordingly, as shown in Fig. 8B, the surface roughness of the substrate after solidification increases. By stopping the incidence of the first laser pulse LP1 and performing the incidence of the second laser pulse LP2, the surface portion of the substrate is melted. Here, the depth of the melted portion is at most 0.3 µm. As shown in Fig. 8B, the root-mean-square roughness of the surface formed by the first laser pulse LP1 is in a range of 16 nm to 18 nm. Since roughness remains before incidence of the second laser pulse LP2, the shallow region from the surface to about 0.3 µm is re-melted by the use of the second laser pulse LP2.

Here, a condition is preferably used in which dopants in a deep region is activated by the use of the first laser pulse LP1 and the substantial melting of a shallow region does not occur at that time. Then, the shallow region is melted by the use of the second laser pulse LP2. Accordingly, both the shallow region (amorphous region) and the deep region can be activated without roughening the surface.

The foil owing points can be thought from the above-mentioned simulation results.
(1) By performing the incidence of the second laser pulse LP2 after starting the incidence of the first laser pulse LP1, it is possible to reduce the pulse energy density of the second laser pulse LP2 necessary for melting the surface portion up to a predetermined depth.
(2) When the surface portion is melted, cooled, and crystallized by performing the incidence of the second laser pulse LP2 before the surface temperature of the substrate becomes higher than the melting point of amorphous silicon in the incidence period of the first laser pulse LP1, it is possible to lower the pulse energy density of the second laser pulse LP2 and it is difficult to re-melt the substrate surface even by the incidence of the first laser pulse LP1. Accordingly, it is possible to activate dopants in a deep region without increasing the surface roughness.
(3) When the surface portion of the substrate is melted by the incidence of the first laser pulse LP1 and the incidence of the second laser pulse LP2 is performed in this state, it is thought that the pulse energy density of the second laser pulse LP2 is preferably set to be relatively high. This is because it is thought that even when the melting state of the surface portion is non-uniform, the temperature of the surface portion can be raised uniformly.

Fig. 10 shows an example of a dopant concentration distribution in the depth direction of the semiconductor substrate 50. The horizontal axis in Fig. 10 represents the depth from the second surface 50B of the semiconductor substrate 50 in the unit of "µm". The vertical axis in Fig. 10 represents the concentration of doped dopants in the unit of "cm⁻³" in terms of logarithmic scales.

The concentration of boron (B) has a maximum value at a depth of 0.3 µm from the second surface 50B. The concentration of phosphorus (P) has a maximum value at a depth of 1.8 µm from the second surface 50B. The foot (tail) of the concentration distribution of phosphorus (P) reaches the depth of 3 µm from the second surface 50B. The depth at which the dopant concentration of boron and the dopant concentration of phosphorus are equal to each other corresponds to the boundary between the high-concentration layer 57a and the low-concentration layer 56a (Fig. 2B).

Dopants (phosphorus) implanted into a relatively deep region, for example, a region with a depth deeper than 1 µm, with a relatively low concentration are activated by the first laser pulse LP1 (Fig. 3A) with a relatively long pulse width. Dopants (boron) implanted into a relatively shallow region, for example, a region with a depth equal to or shallower than 1 µm, with a relatively high concentration are activated by the second laser pulse LP2 (Fig. 3A) with a relatively short pulse width. The second laser pulse LP2 melts the semiconductor substrate 50 up to a position deeper than the region into which dopants are ion-implanted with a high concentration and which is changed to an amorphous state. The semiconductor substrate 50 of the incidence region 40 (Fig. 3B) is melted by the irradiation with the second laser pulse LP2. When the melted region is solidified, a crystal grows in a liquid epitaxial manner from the single crystalline region. Accordingly, the re-crystallization of the amorphous region and the activation of dopants (boron) are performed.

The example where boron is implanted into the high-concentration layer 57a with a relatively small depth and phosphorus is implanted into the low-concentration layer 56a with a relatively large depth is described above, but the same activation is performed when other dopants are implanted. The same conductive type dopants may be implanted into the high-concentration layer 57a and the low-concentration layer 56a. For example, phosphorus may be implanted into both the high-concentration layer 57a and the low-concentration layer 56a. In this case, an n type layer with a high concentration is formed in a shallow region and an n type layer with a low concentration is formed in a deep region.

The activation of dopants in the deep low-concentration layer 56a (Fig. 2B) by irradiation with the first laser pulse LP1 (Fig. 3A) will be described below with reference to Figs. 11 and 12.

Fig. 11 shows the simulation result of the relationship between the end-point temperature of a silicon wafer and the pulse width when the silicon wafer is irradiated with the first laser pulse LP1. The horizontal axis represents the pulse width PW1 of the first laser pulse LP1 in the unit of "µs" and the vertical axis represents the end-point temperature in the unit of "K". The wavelength of the first laser pulse LP1 is set to 915 nm. The irradiation condition of the first laser pulse LP1 is set to a condition in which the surface temperature of the silicon wafer reaches the melting point (about 1690 K) of silicon. Solid lines a and b in Fig. 11 represent the end-point temperatures at the positions with depths of 3 µm and 100 µm from the surface of the silicon wafer.

When the pulse width is short, it can be seen that heat is difficult to transfer to a deep region. In order to activate the dopants at the position with a depth of 3 µm, it is preferable that the pulse width be set to 5 µs or longer. When the pulse width is excessively long, the temperature of a deep region with a depth of about 100 µm, that is, the first surface 50T (Fig. 2B) on which an element structure is formed, is raised.

A dopant concentration distribution in the depth direction and a carrier concentration distribution after annealing are shown in Fig. 12. The horizontal axis represents the depth from the surface of the silicon wafer in the unit of "µm" and the vertical axis represents the concentration in the unit of "cm⁻³". Solid line a represents the phosphorus concentration when phosphorus ions are implanted under the conditions of acceleration energy of 2 MeV and a dose of 3×10¹³ cm⁻². This dopant concentration distribution corresponds to the dopant concentration distribution in the low-concentration layer 56a (Fig. 2B). Solid line b represents the carrier concentration after being irradiated with the first laser pulse LP1. The irradiation with a laser beam is performed under the conditions of a pulse width of 20 µs and a power density of 360 kW/cm² on the irradiated surface. From the results shown in Fig. 12, it is confirmed that about 70% or more of implanted dopants are activated.

Recovery of a region changed to an amorphous state by the ion implantation will be described below with reference to Figs. 13A to 13C.

Fig. 13A is a TEM image illustrating a cross-section of the surface portion of a silicon wafer into which phosphorus ions are implanted. The ion implantation of phosphorus is performed under the conditions of acceleration energy of 100 keV and a dose of 2×10¹⁵ cm⁻². These ion implantation conditions correspond to the ion implantation conditions of dopants into the high-concentration layer 57a. In Fig. 13A, the amorphous region is shown by a relatively light color.

Fig. 13B is a TEM image illustrating a cross-section of the surface portion of a silicon wafer after being irradiated with the second laser pulse LP2 (Fig. 3A). A second harmonic wave of an Nd:YLF laser is used as the second laser pulse LP2. The irradiation with the second laser pulse LP2 is performed using a so-called double pulse method. The pulse width of one laser pulse is 130 ns, the pulse energy density thereof is 1.6 J/cm², and the delay time from the irradiation with a laser pulse of a first shot to the irradiation with a laser pulse of a second shot is 500 ns. In the region melted by the irradiation with a laser beam, since a crystal grows in an epitaxial manner from a single crystalline region below the melted region, an excellent single crystalline layer with a small defect is obtained.

Fig. 13C is a TEM image illustrating a cross-section of the surface portion of a silicon wafer after being irradiated with the first laser pulse LP1 (Fig. 3A). The wavelength of the first laser pulse LP1 is 808 nm. The irradiation with the first laser pulse LP1 is performed under the conditions of a pulse width of 40 µs and a power density of 300 kW/cm². Under these irradiation conditions, the surface of the silicon wafer is not melted. When a deep region (the low-concentration layer 56a in Fig. 2B) of the silicon wafer is melted by the use of a laser pulse, the dopant concentration distribution of the high-concentration layer 57a is broken down. Accordingly, the irradiation with the first laser pulse LP1 is performed under the conditions in which the silicon wafer is not melted. The annealing method of activating dopants without melting the silicon wafer is referred to as "non-melting annealing". On the contrary, the annealing method of temporarily melting the silicon wafer is referred to as "melting annealing". In the non-melting annealing, crystallization proceeds from the top surface and the bottom surface of the amorphous region. A layer in an amorphous state remains substantially at the center in the thickness direction. The crystal quality of the crystallized region is poorer than the crystal quality of the re-crystallized region in Fig. 13B.

As can be seen from the cross-sectional TEM image shown in Figs. 13A to 13C, preferably, the amorphous high-concentration layer 57a (Fig. 2B) is subjected to the melting annealing using the second laser pulse LP2 (Fig. 3A) having a relatively short pulse width and relatively high peak power and the dopants thereof are activated.

Fig. 14A shows an example of a temporal waveform of a laser pulse when the laser annealing is performed using the method according to the embodiment. The horizontal axis represents the elapsed time from the rising of the first laser pulse LP1 in the unit of "µs" and the vertical axis represents light intensity. The pulse width of the first laser pulse LP1 is 15 µs. At the time point when 14 µs has elapsed from the rising edge of the first laser pulse LP1, the second laser pulse LP2 rises. The second laser pulse LP2 is a second harmonic wave of an Nd:YLF laser and the pulse width is 130 ns.

Fig. 14B shows the simulation result of the temperature variation of a silicon wafer when the silicon wafer is irradiated with the first and second laser pulses LP1 and LP2 shown in Fig. 14A. The horizontal axis represents the elapsed time in the unit of "µs" and the vertical axis represents the temperature in the unit of "K". Solid lines a to g in Fig. 14B represent the temperatures at the positions at which the depth from the surface of the silicon wafer is 0 µm, 1 µm, 2 µm, 3 µm, 4 µm, 5 µm, and 100 µm.

When the irradiation with the first laser pulse LP1 is started, the temperature of the silicon wafer rises . At the time point when 14 µs has elapsed from the irradiation start, the surface temperature of the silicon wafer reaches 1660 K close to the melting point of silicon. At this time point, the silicon wafer is not melted. When the second laser pulse LP2 is incident, the surface temperature of the silicon wafer reaches the melting point and the surface portion is melted.

Fig. 14C shows the simulation result of the temporal variation of the melting depth of a silicon wafer. The horizontal axis represents the elapsed time in the unit of "µs" and the vertical axis represents the melting depth in the unit of "µm". By the irradiation with the second laser pulse LP2, it can be seen that the silicon wafer is melted up to a depth of about 0.3 µm. The dopants implanted into a region with a depth shallower than 0.3 µm are activated by melting and re-crystallizing the surface portion.

As shown in Fig. 14B, the temperature of the position with a depth of 5 µm is higher than 1200 K at the time point when about 14 µs has elapsed from the irradiation start with the first laser pulse LP1. Accordingly, the dopants implanted into a region with a depth of about 5 µm which is not melted are activated by solid-phase diffusion.

Fig. 15 shows the relationship between the elapsed time t2-t4 from the falling time t4 of the first laser pulse LP1 to the rising time t2 of the second laser pulse LP2 and the fluence of the second laser pulse LP2 necessary for melting the silicon wafer. The delay time from time t4 to time t2 is represented as td. The horizontal axis represents the delay time td in the unit of "µs". In the region in which the delay time td is negative, the second laser pulse LP2 rises before the falling time t4 of the first laser pulse LP1. The left vertical axis in Fig. 15 represents the fluence of the second laser pulse LP2 in the unit of "J/cm²" and the right vertical axis represents the power of the second laser pulse LP2 in the unit of "W".

Solid line a shown in Fig. 15 represents the simulation result of the fluence of the second laser pulse LP2 under a condition in which the silicon wafer at the position with a depth of 0.3 µm is melted. Solid line b represents the simulation result of the fluence of the second laser pulse LP2 under a condition in which the outermost surface of the silicon wafer is melted. The increasing or decreasing tendencies of both results with the variation of the delay time td are substantially equal to each other. Square symbols shown in Fig. 15 represent the measured value of power of the second laser pulse LP2 when the outermost surface of the silicon wafer is melted. Since the area of the incidence region 40 (Fig. 3B) and the pulse width of the first laser pulse LP1 are constant, the power can be converted into fluence by multiplying the power of the second laser pulse LP2 by a constant. As shown in Fig. 15, the simulation result is sufficiently matched with the actual test result.

The origin (td=0) of the horizontal axis corresponds to the irradiation condition in which the second laser pulse LP2 rises at the same time as the falling of the first laser pulse LP1.

The pulse width of the first laser pulse LP1 is set to 25 µs and the power density on the surface of the silicon wafer is set to 310 kW/cm². The position at which the delay time td is -25 µs corresponds to the irradiation condition in which the second laser pulse LP2 rises at the same time as the rising of the first laser pulse LP1.

When the delay time td is elongated from -25 µs to 0 µs (the rising time t2 of the second laser pulse LP2 is brought close to the falling time t4 of the first laser pulse LP1), the fluence of the second laser pulse LP2 necessary for melting the silicon wafer is lowered. This is because the silicon wafer is pre-heated by the first laser pulse LP1 at the time point at which the second laser pulse LP2 is incident. In the vicinity of the delay time td=0, the fluence of the second laser pulse LP2 necessary for melting the silicon wafer has the minimum value .

As the delay time td is elongated from 0, the fluence of the second laser pulse LP2 necessary for melting the silicon wafer increases. This is because the temperature of the silicon wafer is lowered (the pre-heating effect is reduced) after the falling time t4 of the first laser pulse LP1.

As can be seen from the simulation result and the test result shown in Fig. 15, it is possible to reduce the fluence of the second laser pulse LP2 necessary for melting the silicon wafer by adjusting the irradiating timings of the first laser pulse LP1 and the second laser pulse LP2. In other words, when the area of the incidence area 40 (Fig. 3B) is constant, a solid state laser oscillator having small power can be used as the solid state laser oscillator 31 (Fig. 1) for the second laser pulse LP2. When the power of the solid state laser oscillator 31 is constant, the area of the incidence region 40 can be increased.

The effects of the activation method according to the embodiment will be described with reference to Figs. 16 and 17. An evaluation test of implanting phosphorus (P) as dopants into the silicon wafer and performing activation annealing using the method according to the embodiment was conducted.

Figs. 16 and 17 show the measurement results of the dopant concentration distribution before the activation annealing and the carrier concentration distribution after the activation annealing. The horizontal axis represents the depth in the unit of "µm" and the vertical axis represents the concentration in the unit of "cm⁻³". The dotted lines in Figs. 16 and 17 represent the dopant concentration distribution before the activation annealing. A single crystalline silicon substrate is used as the semiconductor substrate and phosphorus (P) is used as the implanted dopants. The dopant concentration has a local maximum value at positions with depths of 0.2 µm and 1.8 µm. A shallow region with a depth of 0.3 µm or shallower from the surface corresponds to the high-concentration layer 57a (Fig. 2B) and a deep region with a depth of 0.3 µm to about 4 µm corresponds to the low-concentration layer 56a (Fig. 2B). In the evaluation test, phosphorus is employed as the dopants in the shallow high-concentration layer 57a and the deep low-concentration layer 56a, but the activation rate based on the activation annealing exhibits substantially the same tendency as the result of the evaluation test even when p type dopants and n type dopants are respectively employed as the dopants of the high-concentration layer 57a and the low-concentration layer 56a.

In the evaluation test, the pulse width of the first laser pulse LP1 is set to 25 µs and the power density thereof is set to 310 kW/cm². The pulse width of the second laser pulse LP2 is set to 0.15 µs. The fluence of the second laser pulse LP2 is set to a condition in which the melting depth shown in Fig. 15 is 0.3 µm.

Fig. 16 shows the result of the activation annealing under the condition in which the second laser pulse LP2 rises at the same time as the falling time t4 of the first laser pulse LP1 or after time t4. The delay time td from the falling time t4 of the first laser pulse LP1 to the rising time t2 of the second laser pulse LP2 is set to 0 µs, 2 µs, 5 µs, and 10 µs.

Fig. 17 shows the result of the activation annealing under the condition in which the second laser pulse LP2 rises before the falling time t4 of the first laser pulse LP1. The delay time td from the falling time t4 of the first laser pulse LP1 to the rising time t2 of the second laser pulse LP2 is negative. The delay time td from the falling time t4 of the first laser pulse LP1 to the rising time t2 of the second laser pulse LP2 is set to -3 µs, -8 µs, -13 µs, and -18 µs.

As shown in Figs. 16 and 17, when the delay time td is in the range of -18 µs to 10 µs, it can be seen that satisfactory activation is carried out on both the shallow region (the region corresponding to the high-concentration layer 57a) and the deep region (the region corresponding to the low-concentration layer 56a). In the region with a depth shallower than 0.3 µm, the dopants are activated when the high-concentration layer 57a is temporally melted by the irradiation with the second laser pulse LP2 and is then solidified.

The pulse width in the order of micro seconds of the first laser pulse LP1 is much shorter than the annealing time using an electric furnace. Accordingly, in order to perform satisfactory activation, a temperature higher than the annealing using an electric furnace is necessary. When the temperature of silicon is higher than about 1200 K, activation of the dopants is started even with the pulse width (heating time) in the order of micro seconds . As can be seen from the simulation result shown in Fig. 14B, when the temperature of the region with a depth of 1 µm to 5 µm is higher than 1200 K by the irradiation with the first laser pulse LP1, the deep region with a depth of 5 µm or shallower is activated by the irradiation with the first laser pulse LP1. It is confirmed from the result of the evaluation test shown in Figs. 16 and 17 that the dopants in the region with a depth of 0.3 µm to 4 µm are activated by the irradiation with the first laser pulse LP1.

When the pulse width of the first laser pulse LP1 becomes longer, the region reaching the temperature of 1200 K becomes deeper. Therefore, when it is intended to activate the dopants in a deeper region, the pulse width of the first laser pulse LP1 only has to increase. The pulse width of the first laser pulse LP1 is determined depending on a target depth for activation. When the pulse width of the first laser pulse LP1 increases to activate a deeper region, it is preferable that the power density be lowered so as not to melt the surface of the semiconductor substrate. The reason why the surface of the semiconductor substrate should not be melted with the first laser pulse LP1 will be described below.

When the surface portion of the semiconductor substrate is melted by the irradiation with the second laser pulse LP2 having a short pulse width, the temperature of the surface portion of the semiconductor substrate rapidly rises and the melting is started substantially in the entire range of the incidence region of the laser pulse substantially at the same time. When the first laser pulse LP1 having a long pulse width is incident, the substrate temperature slowly rises as shown in Fig. 14B. When the temperature has a deviation in the incidence region 40 (Fig. 3B), a melted region and a non-melted region are mixed in the incidence region 40. When the melted region and the non-melted region are mixed, unevenness is generated on the surface of the semiconductor substrate after solidification. In order to keep the crystal quality of the surface portion of the semiconductor substrate high, it is preferable that the irradiation condition of the first laser pulse LP1 be set to a condition in which the surface of the semiconductor substrate is not melted.

A desirable condition of the incidence timings of the first laser pulse LP1 and the second laser pulse LP2 when the shallow high-concentration layer 57a (Fig. 2B) and the deep low-concentration layer 56a (Fig. 2B) are subjected to activation annealing will be described below. As shown in Figs. 16 and 17, when the pulse width of the first laser pulse LP1 is 25 µs, it is confirmed that satisfactory activation can be carried out in the range of the delay time td of -18 µs to 10 µs.

When the pulse width of the first laser pulse LP1 is defined as PW1, the falling time of the first laser pulse is defined as t4, and the rising time of the second laser pulse is defined as t2, it is confirmed from the evaluation test that satisfactory activation is carried out in the range of -0.7×PW1≤t2-t4≤0.4×PW1. Even when the pulse width of the first laser pulse LP1 is changed, the variation of the substrate temperature in the period from the rising of the first laser pulse LP1 to the falling thereof has the same tendency. Therefore, under the condition that the second laser pulse LP2 rises at time t2 before the falling time t4 of the first laser pulse LP1, it is thought that satisfactory activation annealing can be carried out in the range of -0.7×PW1≤t2-t4≤0 even though the pulse width of the first laser pulse LP1 changes.

When the second laser pulse LP2 rises at time t2 after the falling time t4 of the first laser pulse LP1, satisfactory re-crystallization and activation can be carried out by adjusting the fluence of the second laser pulse LP2. Here, as shown in Fig. 15, when the delay time td=t2-t4 increases, the fluence of the second laser pulse LP2 should be increased. When the delay time td excessively increases, the shift distance of the semiconductor substrate from the falling time t4 of the first laser pulse LP1 to the rising time t2 of the second laser pulse LP2 cannot be ignored. That is, the incidence region 40B of the second laser pulse LP2 is displayed in the Y direction relative to the incidence region 40A of the first laser pulse LP1 shown in Fig. 3C. In order to cause the first laser pulse LP1 and the second laser pulse LP2 to be incident substantially on the same region, it is preferable that the delay time td=t2-t4 be set to be equal to or shorter than 1/10 of a pulse repetition period of the first laser pulse LP1. That is, when the pulse repetition period of the first laser pulse LP1 is defined as T, it is preferable that t2-t4≤T/10 be satisfied.

Fig. 18A shows an example of a scanning path when the entire range of the surface of the semiconductor substrate (silicon wafer) 50 is annealed with the first laser pulse LP1 and the second laser pulse LP2. As shown in Fig. 1, the stage 41 is caused to move while fixing the path of a laser beam and periodically irradiating the semiconductor substrate 50 with the first laser pulse LP1 and the second laser pulse LP2. Accordingly, the surface of the semiconductor substrate 50 is scanned with the first laser pulse LP1 and the second laser pulse LP2. The horizontal scanning direction is defined as the Y direction and the vertical scanning direction is defined as the X direction. The scanning is performed in the reciprocating manner in the Y direction (horizontal scanning direction).

An annealing method according to a comparative example will be described with reference to Figs. 18B and 18C. In the comparative example, a continuous-wave (CW) laser beam is used as a first laser beam for activating a deep region and a pulse laser beam is used as a second laser beam for activating a shallow region.

Fig. 18B shows the positional relationship between a first incidence region 60A of the first laser beam and a second incidence region 60B of the second laser beam. Both have a strip shape elongated in the X direction. The second incidence region 60B is included in the first incidence region 60A. The first incidence region 60A and the second incidence region 60B are scanned in the negative direction of the Y axis while maintaining this positional relationship. Paying attention to one point on the surface of the semiconductor substrate 50, the first laser beam is applied from the time point at which the front edge (the right edge in Fig. 18B) of the first incidence region 60A passes the point to the time point at which the rear edge (the left edge in Fig. 18B) passes the point. The second laser beam is applied from the rising time to the falling time thereof.

Paying attention to one point on the surface of the semiconductor substrate 50, the elapsed time from the incidence time t10 of the first laser beam to the incidence time t11 of the second laser beam depends on the positional relationship between the first incidence region 60A and the second incidence region 60B. More specifically, it depends on the scanning speed and the gap between the right edge of the first incidence region 60A and the edge of the second incidence region 60B.

Fig. 18C shows the positional relationship between the first incidence region 60A and the second incidence region 60B and the irradiation timing of a laser beam applied to one point on the surface of the semiconductor substrate 50 when the first incidence region 60A and the second incidence region 60B are scanned in the positive direction of the Y axis. The elapsed time from the incidence time t10 of the first laser beam to the incidence time t11 of the second laser beam depends on the scanning speed and the gap between the left edge of the first incidence region 60A and the edge of the second incidence region 60B.

As shown in Figs. 18B and 18C, the elapsed time from the incidence time t10 of the first laser beam to the incidence time t11 of the second laser beam varies between when the scanning is performed in the negative direction of the Y axis and when the scanning is performed in the positive direction thereof. On the contrary, in the embodiment, the elapsed time from the incidence time of the first laser pulse LP1 to the incidence time of the second laser pulse LP2 does not depend on the relative positional relationship between the incidence regions of the two laser pulses and is equal to the time interval between the rising times of the first laser pulse LP1 and the second laser pulse LP2. Accordingly, when the scanning is performed in any of the positive and negative directions of the Y axis, the elapsed time from the incidence time of the first laser pulse LP1 to the incidence time of the second laser pulse LP2 is constant. Therefore, it is possible to perform the reciprocating scanning in the Y direction. By performing the reciprocating scanning, it is possible to reduce the annealing time. In the forward and backward paths, it is not necessary to adjust the relative positional relationship between the paths of the first laser pulse LP1 and the second laser pulse LP2. Accordingly, a complicated mechanism for adjusting an optical system is not necessary.

In the embodiment, when the wavelength of the first laser pulse LP1 is excessively short, laser energy is absorbed in a very shallow region of the silicon wafer and it is thus difficult to efficiently heat a deep region. On the contrary, when the wavelength of the first laser pulse LP1 is excessively long, the laser energy is not absorbed in the silicon wafer. In order to efficiently heat the low-concentration layer 56a (Fig. 2B) of the silicon wafer with the first laser pulse LP1, it is preferable that the wavelength be set to be equal to or longer than 550 nm and equal to or shorter than 950 nm.

Light with a wavelength of 550 nm permeates the silicon substrate up to a depth of about 1 µm. Accordingly, when the wavelength of the first laser pulse LP1 is set to 550 nm, it is possible to efficiently heat the region with a depth of 1 µm or shallower. A deep region with a depth deeper than 1 µm is heated by heat conduction. When the wavelength of the first laser pulse LP1 is set to 650 nm, it is possible to efficiently heat a region with a depth of about 3 µm or shallower. When the wavelength of the first laser pulse LP1 is set to 700 nm, it is possible to efficiently heat a region with a depth of about 5 µm or shallower. When the thickness of the silicon substrate is 100 µm and the wavelength of the first laser pulse LP1 is set to be longer than 950 nm, the laser energy passing through the silicon substrate increases.

In order to activate the dopants of the deep low-concentration layer 56a (Fig. 2B), it is preferable that the light penetration length of the first laser pulse LP1 into the semiconductor substrate 50 be set to be longer than the depth from the second surface 50B of the semiconductor substrate 50 to the bottom surface of the low-concentration layer 56a. In order to reduce waste light energy passing through the semiconductor substrate 50, it is preferable that the light penetration length of the first laser pulse LP1 be set to be shorter than the thickness of the semiconductor substrate 50. The wavelength of the first laser pulse LP1 is selected so as to satisfy the above-mentioned light penetration length. Here, the "light penetration length" means the distance at which the light intensity is attenuated to 1/e.

The irradiation conditions of the first laser pulse LP1, for example, the pulse width and the power density, are preferably set to conditions in which the surface of the semiconductor substrate is not melted and activation of the dopants in the low-concentration layer 56a is started. Specifically, it is preferable that the irradiation condition be set to a condition in which the temperature of the bottom surface of the low-concentration layer 56a is higher than 1200 K.

It is preferable that the second laser pulse LP2 include green wavelength components which can be easily absorbed in silicon so as to efficiently melt the high-concentration layer 57a (Fig. 2B) of the silicon wafer. Because of the pre-heating effect of the first laser pulse LP1, light with a wavelength larger than that of green light can be easily absorbed in silicon. Therefore, the wavelength of the second laser pulse LP2 may be set to an infrared region with a wavelength of about 1 µm. Since light with a wavelength in the infrared region penetrates a deep region of the silicon substrate, a deeper region is melted than that in a case where light with a green wavelength region is used as the second laser pulse LP2.

Manufacturing an IGBT is exemplified in the above-mentioned embodiment, but the method according to the above-mentioned embodiment can be applied to manufacture a semiconductor device requiring for activating dopants of the surface portion of one surface of a semiconductor substrate and suppressing a rise in temperature of the opposite surface.

## Claims

1. A semiconductor device manufacturing method for activating dopants in a high-concentration layer and a low-concentration layer of a semiconductor substrate by irradiating a surface of the semiconductor substrate with two types of laser pulses, dopant concentration of the low-concentration layer being lower than that of the high-concentration layer, the low-concentration layer being disposed deeper than the high-concentration layer, and the high-concentration layer being in an amorphous state comprising:
a first step of irradiating the surface of the semiconductor substrate with a first laser pulse having a relatively low peak power and a relatively long pulse width to activate the dopants in the low-concentration layer without melting the amorphous high-concentration layer; and
a second step of irradiating the surface of the semiconductor substrate with a second laser pulse having a relatively high peak power and a relatively short pulse width to melt the amorphous high-concentration layer and activate the dopants in the amorphous high-concentration layer,
wherein the first laser pulse and the second laser pulse are incident on the semiconductor substrate at a timing satisfying a condition of 0 < t2-t4 ≤ T/10, where t4 represents the falling time of the first laser pulse, t2 represents the rising time of the second laser pulse, and T represents the repetition period of the first laser pulse.

2. The semiconductor device manufacturing method according to claim 1, wherein an irradiation condition of the second laser pulse in the second step is a condition in which the high-concentration layer is solidified and crystallized after being melted.

3. The semiconductor device manufacturing method according to claim 1, wherein a light source of the first laser pulse is a semiconductor laser oscillator and a light source of the second laser pulse is a solid state laser oscillator that emits a second harmonic wave.

4. The semiconductor device manufacturing method according to claim 1, wherein a length of a flat portion is equal to or longer than 5 µs when the pulse waveform of the first laser pulse has the flat portion, the full width at half maximum of the pulse waveform is equal to or longer than 10 µs when the first laser pulse does not have the flat portion, and the pulse width of the second laser pulse is equal to or shorter than 1 µs.

5. The semiconductor device manufacturing method according to claim 1, wherein the wavelength of the first laser pulse is equal to or shorter than 950 nm.

6. The semiconductor device manufacturing method according to claim 1, wherein an incidence region of the second laser pulse is disposed inside an incidence region of the first laser pulse and the area of the incidence region of the second laser pulse is in a range of 50% to 100% of the area of the incidence region of the first laser pulse.

7. The semiconductor device manufacturing method according to claim6, wherein the incidence region of the first laser pulse and the incidence region of the second laser pulse substantially conforms to each other.

8. The semiconductor device manufacturing method according to claim 1, further comprising:
a step of periodically irradiating the surface of the semiconductor substrate with the first laser pulse and the second laser pulse while causing the semiconductor substrate to move in a first direction parallel to the surface thereof; and
a step of periodically irradiating the surface of the semiconductor substrate with the first laser pulse and the second laser pulse while causing the semiconductor substrate to move in a direction opposite to the first direction.

9. The semiconductor device manufacturing method according to claim 1, wherein the wavelengthof the first laser pulse is selected so that the light penetration length into the semiconductor substrate is longer than the depth from the surface of the semiconductor substrate to the bottom of the low-concentration layer.

10. The semiconductor device manufacturing method according to claim 1, wherein the wavelength of the first laserpulse is selected so that the light penetration length into the semiconductor substrate is shorter than the thickness of the semiconductor substrate.

11. A laser annealing apparatus comprising:
a first laser oscillator that emits a pulse laser beam;
a second laser oscillator that emits a pulse laser beam of which the pulse width is shorter than a pulse width of the pulse laser beam emitted from the first laser oscillator and the peak power is larger than a peak power of the pulse laser beam emitted from the first laser oscillator;
a propagating optical system that causes the pulse laser beam emitted from the first laser oscillator and the pulse laser beam emitted from the second laser oscillator to be incident on a same region of a surface of a semiconductor substrate to be annealed; and
a control unit that controls laser pulse emission timings of the first laser oscillator and the second laser oscillator in such a manner that the first laser pulse emitted from the first laser oscillator and the second laser pulse emitted from the second laser oscillator are incident on the semiconductor substrate at a timing satisfying a condition of 0 < t2-t4 ≤ T/10, where t4 represents the falling time of the first laser pulse, t2 represents the rising time of the second laser pulse, and T represents the repetition period of the first laser pulse.

## Patentansprüche

1. Verfahren zur Herstellung einer Halbleitervorrichtung zur Aktivierung von Dotierstoffen in einer Hochkonzentrationsschicht und einer Schwachkonzentrationsschicht eines Halbleitersubstrats durch Bestrahlen einer Oberfläche des Halbleitersubstrats mit zwei Arten von Laserimpulsen, wobei die Dotierstoffkonzentration der Schwachkonzentrationsschicht geringer als die der Hochkonzentrationsschicht ist, wobei die Schwachkonzentrationsschicht tiefer als die Hochkonzentrationsschicht angeordnet ist, und sich die Hochkonzentrationsschicht in einem amorphen Zustand befindet, das Folgendes aufweist:
einen ersten Schritt des Bestrahlens der Oberfläche des Halbleitersubstrats mit einem ersten Laserimpuls, der eine relativ schwache Spitzenleistung und eine relativ lange Impulsbreite aufweist, um die Dotierstoffe in der Schwachkonzentrationsschicht zu aktivieren, ohne die amorphe Hochkonzentrationsschicht zu schmelzen; und
einen zweiten Schritt des Bestrahlens der Oberfläche des Halbleitersubstrats mit einem zweiten Laserimpuls mit einer relativ hohen Spitzenleistung und einer relativ kurzen Impulsbreite, um die amorphe Hochkonzentrationsschicht zu schmelzen und die Dotierstoffe in der amorphen Hochkonzentrationsschicht zu aktivieren,
wobei der erste Laserimpuls und der zweite Laserimpuls auf das Halbleitersubstrat mit einer Zeitvorgabe auftreffen, die eine Bedingung von 0 < t2-t4 ≤ T/10 erfüllt, wobei t4 die Abnahmezeit des ersten Laserimpulses repräsentiert, t2 die Anstiegszeit des zweiten Laserimpulses repräsentiert, und T die Wiederholungsperiode des ersten Laserimpulses repräsentiert.

2. Verfahren zur Herstellung einer Halbleitervorrichtung gemäß Anspruch 1, wobei ein Bestrahlungszustand des zweiten Laserimpulses in dem zweiten Schritt ein Zustand ist, in dem die Hochkonzentrationsschicht ausgehärtet und kristallisiert wird, nachdem sie geschmolzen worden ist.

3. Verfahren zur Herstellung einer Halbleitervorrichtung gemäß Anspruch 1, wobei eine Lichtquelle des ersten Laserimpulses ein Halbleiterlaseroszillator ist und eine Lichtquelle des zweiten Laserimpulses ein Feststofflaseroszillator ist, der eine zweite harmonische bzw. Oberwelle emittiert.

4. Verfahren zur Herstellung einer Halbleitervorrichtung gemäß Anspruch 1, wobei eine Länge eines flachen Teil 5 µs entspricht oder länger ist, wenn die Impulswellenform des ersten Laserimpulses den flachen Teil aufweist, die vollständige Breite bei halbem Maximum der Impulswellenform gleich 10 µs entspricht oder länger ist, wenn der erste Laserimpuls nicht den flachen Teil aufweist, und die Impulsbreite des zweiten Laserimpulses kürzer oder gleich 1 µs ist.

5. Verfahren zur Herstellung einer Halbleitervorrichtung gemäß Anspruch 1, wobei die Wellenlänge des ersten Laserimpulses kürzer oder gleich 950 nm ist.

6. Verfahren zur Herstellung einer Halbleitervorrichtung gemäß Anspruch 1, wobei ein Einfallsbereich des zweiten Laserimpulses innerhalb eines Einfallsbereichs des ersten Laserimpulses angeordnet ist, und die Fläche des Einfallsbereichs des zweiten Laserimpulses in einem Bereich von 50% bis 100% der Fläche des Einfallsbereichs des ersten Laserimpulses liegt.

7. Verfahren zur Herstellung einer Halbleitervorrichtung gemäß Anspruch 6, wobei der Einfallsbereich des ersten Laserimpulses und der Einfallsbereich des zweiten Laserimpulses im Wesentlichen miteinander übereinstimmen.

8. Verfahren zur Herstellung einer Halbleitervorrichtung gemäß Anspruch 1, das ferner Folgendes aufweist:
einen Schritt des periodischen Bestrahlens der Oberfläche des Halbleitersubstrats mit dem ersten Laserimpuls und dem zweiten Laserimpuls, während veranlasst wird, dass sich das Halbleitersubstrat in einer ersten Richtung parallel zu dessen Oberfläche bewegt; und
einen Schritt des periodischen Bestrahlens der Oberfläche des Halbleitersubstrats mit dem ersten Laserimpuls und dem zweiten Laserimpuls, während veranlasst wird, dass sich das Halbleitersubstrat in einer Richtung entgegengesetzt zu der ersten Richtung bewegt.

9. Verfahren zur Herstellung einer Halbleitervorrichtung gemäß Anspruch 1, wobei die Wellenlänge des ersten Laserimpulses so ausgewählt wird, dass die Lichtpenetrationslänge in das Halbleitersubstrat länger als die Tiefe von der Oberfläche des Halbleitersubstrats zu der Unterseite der Schwachkonzentrationsschicht ist.

10. Verfahren zur Herstellung einer Halbleitervorrichtung gemäß Anspruch 1, wobei die Wellenlänge des ersten Laserimpulses so ausgewählt wird, dass die Lichtpenetrationslänge in das Halbleitersubstrat kürzer als die Dicke des Halbleitersubstrats ist.

11. Laserglühvorrichtung, die Folgendes aufweist:
einen ersten Laseroszillator, der einen Impulslaserstrahl emittiert;
einen zweiten Laseroszillator, der einen Impulslaserstrahl emittiert, dessen Impulsbreite kürzer als eine Impulsbreite des Impulslaserstrahls ist, der von dem ersten Laseroszillator emittiert wird und die Spitzenleistung größer als eine Spitzenleistung des Impulslaserstrahls ist, der von dem ersten Laseroszillator emittiert wird;
ein übertragendes, optisches System, das bewirkt, dass der Impulslaserstrahl, der von dem ersten Laseroszillator emittiert wird, und der Impulslaserstrahl, der von dem zweiten Laseroszillator emittiert wird, auf einen gleichen Bereich einer Oberfläche eines Halbleitersubstrats auftreffen, der geglüht werden soll; und
eine Steuereinheit, die die Zeitvorgaben der Laserimpulsemission des ersten Laseroszillators und des zweiten Laseroszillators in einer solchen Art und Weise steuert, das der erste Laserimpuls, der von dem ersten Laseroszillator emittiert wird, und der zweite Laserimpuls, der von dem zweiten Laseroszillator emittiert wird, auf das Halbleitersubstrat mit einer Zeitvorgabe treffen, die eine Bedingung von 0 < t2-t4 ≤ T/10 erfüllt, wobei t4 die Abnahmezeit des ersten Laserimpulses repräsentiert, t2 die Anstiegszeit des zweiten Laserimpulses repräsentiert, und T die Wiederholungsperiode des ersten Laserimpulses repräsentiert.

## Revendications

1. Procédé de fabrication d'un dispositif semiconducteur pour activer des dopants dans une couche à forte concentration et une couche à faible concentration d'un substrat semiconducteur en irradiant une surface du substrat semiconducteur avec deux types d'impulsions laser, la concentration en dopant de la couche à faible concentration étant inférieure à celle de la couche à forte concentration, la couche à faible concentration étant disposée plus en profondeur que la couche à forte concentration, et la couche à forte concentration étant dans un état amorphe, comprenant :
une première étape consistant à irradier la surface du substrat semiconducteur avec une première impulsion laser ayant une puissance crête relativement faible et une largeur d'impulsion relativement longue pour activer les dopants dans la couche à faible concentration sans faire fondre la couche amorphe à forte concentration ; et
une deuxième étape consistant à irradier la surface du substrat semiconducteur avec une deuxième impulsion laser ayant une puissance crête relativement élevée et une largeur d'impulsion relativement courte pour faire fondre la couche amorphe à forte concentration et pour activer les dopants dans la couche amorphe à forte concentration,
dans lequel la première impulsion laser et la deuxième impulsion laser sont incidentes au substrat semiconducteur à un instant satisfaisant la condition 0 < t2-t4 ≤ T/10, où t4 représente l'instant de front descendant de la première impulsion laser, t2 représente l'instant de front montant de la deuxième impulsion laser, et T représente la période de répétition de la première impulsion laser.

2. Procédé de fabrication d'un dispositif semiconducteur selon la revendication 1, dans lequel une condition d'irradiation de la deuxième impulsion laser dans la deuxième étape est une condition dans laquelle la couche à forte concentration est solidifiée et cristallisée après avoir été fondue.

3. Procédé de fabrication d'un dispositif semiconducteur selon la revendication 1, dans lequel une source de lumière de la première impulsion laser est un oscillateur laser à semiconducteur et une source de lumière de la deuxième impulsion laser est un oscillateur laser à l'état solide qui émet une deuxième onde harmonique.

4. Procédé de fabrication d'un dispositif semiconducteur selon la revendication 1, dans lequel une longueur d'une partie plate est égale ou supérieure à 5 µs lorsque la forme d'onde d'impulsion de la première impulsion laser a la partie plate, la largeur complète à la moitié du maximum de la forme d'onde d'impulsion étant égale ou supérieure à 10 µs lorsque la première impulsion laser ne comporte pas la partie plate, et la largeur d'impulsion de la deuxième impulsion laser étant égale ou inférieure à 1 µs.

5. Procédé de fabrication d'un dispositif semiconducteur selon la revendication 1, dans lequel la longueur d'onde de la première impulsion laser est égale ou inférieure à 950 nm.

6. Procédé de fabrication d'un dispositif semiconducteur selon la revendication 1, dans lequel une région d'incidence de la deuxième impulsion laser est disposée à l'intérieur d'une région d'incidence de la première impulsion laser et la surface de la région d'incidence de la deuxième impulsion laser est dans une plage de 50 % à 100% de la surface de la région d'incidence de la première impulsion laser.

7. Procédé de fabrication d'un dispositif semiconducteur selon la revendication 6, dans lequel la région d'incidence de la première impulsion laser et la région d'incidence de la deuxième impulsion laser se conforment sensiblement l'une à l'autre.

8. Procédé de fabrication d'un dispositif semiconducteur selon la revendication 1, comprenant en outre :
une étape consistant à irradier périodiquement la surface du substrat semiconducteur avec la première impulsion laser et la deuxième impulsion laser tout en amenant le substrat semiconducteur à se déplacer dans une première direction parallèle à sa surface ; et
une étape consistant à irradier périodiquement la surface du substrat semiconducteur avec la première impulsion laser et la deuxième impulsion laser tout en amenant le substrat semiconducteur à se déplacer dans une direction opposée à la première direction.

9. Procédé de fabrication d'un dispositif semiconducteur selon la revendication 1, dans lequel la longueur d'onde de la première impulsion laser est sélectionnée de sorte que la longueur de pénétration de la lumière dans le substrat semiconducteur est plus longue que la profondeur entre la surface du substrat semi-conducteur et le bas de la couche à faible concentration.

10. Procédé de fabrication d'un dispositif semiconducteur selon la revendication 1, dans lequel la longueur d'onde de la première impulsion laser est sélectionnée de sorte que la longueur de pénétration de la lumière dans le substrat semiconducteur est plus courte que l'épaisseur du substrat semiconducteur.

11. Appareil de recuit laser comprenant :
un premier oscillateur laser qui émet un faisceau laser impulsionnel ;
un deuxième oscillateur laser qui émet un faisceau laser impulsionnel dont la largeur d'impulsion est inférieure à la largeur d'impulsion du faisceau laser impulsionnel émis par le premier oscillateur laser et dont la puissance crête est supérieure à la puissance crête du faisceau laser impulsionnel émis par le premier oscillateur laser ;
un système optique à propagation qui fait en sorte que le faisceau laser impulsionnel émis par le premier oscillateur laser et le faisceau laser impulsionnel émis par le deuxième oscillateur laser soient incidents à une même région d'une surface d'un substrat semiconducteur ; et
une unité de commande qui commande les instants d'émission d'impulsions laser du premier oscillateur laser et du deuxième oscillateur laser de telle sorte que la première impulsion laser émise par le premier oscillateur laser et la deuxième impulsion laser émise par le deuxième oscillateur laser sont incidentes au substrat semiconducteur à un instant satisfaisant la condition 0 < t2-t4 ≤ T/10, où t4 représente l'instant de front descendant de la première impulsion laser, t2 représente l'instant de front montant de la deuxième impulsion laser, et T représente la période de répétition de la première impulsion laser.
